# EUROPEAN PATENT APPLICATION

(11) **EP 4 836 623 A1**
(43) Date of publication of application: **04.11.2026**
(21) Application number: 24921627.6
(22) Date of filing: 12.11.2024
(51) Int. Cl.: H10B 12/00

(54) **CHIP AND PREPARATION METHOD THEREFOR, AND MEMORY AND ELECTRONIC DEVICE**

(30) Priority: 04.02.2024 CN 202410161330
(71) Applicant: Huawei Technologies Co., Ltd., Shenzhen, Guangdong 518129 (CN)
(72) Inventor: ZHAN, Shijie, Shenzhen, Guangdong 518129 (CN); WU, Ying, Shenzhen, Guangdong 518129 (CN); ZHAO, WanPeng, Shenzhen, Guangdong 518129 (CN); XU, Jeffrey Junhao, Shenzhen, Guangdong 518129 (CN)
(74) Representative: Huawei European IPR
(86) International application number: PCT/CN2024/131593
(87) International publication number: WO 2025/161605

(57) **Abstract**

This application relates to the semiconductor field, and provides a chip and a fabrication method therefor, a memory, and an electronic device, to avoid a case in which a size of a vertical transistor cannot be scaled due to process limitation. The chip includes the vertical transistor, and the vertical transistor includes: a first electrode, a channel, and a second electrode that are sequentially stacked on a substrate, where the channel includes a trench; a first gate dielectric layer and a second gate dielectric layer, where both the first gate dielectric layer and the second gate dielectric layer are in contact with side walls of the trench; and both the first gate dielectric layer and the second gate dielectric layer are located in the trench, or both the first gate dielectric layer and the second gate dielectric layer are located outside the trench; and a first gate and a second gate that are spaced apart, where the first gate is disposed on a side that is of the first gate dielectric layer and that faces away from the channel, and the second gate is disposed on a side that is of the second gate dielectric layer and that faces away from the channel.

## Description

This application claims priority to Chinese Patent Application No. 202410161330.2, filed with the China National Intellectual Property Administration on February 4, 2024 and entitled "CHIP AND FABRICATION METHOD THEREFOR, MEMORY, AND ELECTRONIC DEVICE", which is incorporated herein by reference in its entirety.

### TECHNICAL FIELD

This application relates to the semiconductor field, and in particular, to a chip and a fabrication method therefor, a memory, and an electronic device.

### BACKGROUND

Memories are widely used in electronic devices. With the development of chip technologies, the size of memories, like that of processors, is continuously scaled down to improve density and memory performance. A memory includes a plurality of memory cells, and each memory cell includes a transistor and a capacitor.

In the conventional technology, a vertical transistor is used and the vertical transistor is integrated with a capacitor structure in a vertical direction, to implement a high-density memory cell. This holds promise for further scaling of the memory.

However, the mainstream vertical transistor structure is a gate-all-around structure. A first via needs to be provided in a gate, and a gate dielectric layer is first deposited in the first via. Then, a second via is provided at a bottom of the gate dielectric layer, and a channel is formed in the second via, to enable the channel to be in contact with a bottom electrode. In other words, on a plane perpendicular to the vertical direction, the size of the vertical transistor is affected by sizes of the gate, the gate dielectric layer, and the channel. As a result, one transistor occupies a relatively large area, which is not conducive to scaling of the vertical transistor.

### SUMMARY

To resolve the foregoing technical problem, this application provides a chip and a fabrication method therefor, a memory, and an electronic device, to avoid a case in which a size of a vertical transistor cannot be scaled due to process limitation.

According to a first aspect, this application provides a chip. The chip includes a vertical transistor, and the vertical transistor includes a first electrode, a channel, and a second electrode that are sequentially stacked on a substrate, where the channel includes a trench; a first gate dielectric layer and a second gate dielectric layer, where both the first gate dielectric layer and the second gate dielectric layer are in contact with side walls of the trench; and both the first gate dielectric layer and the second gate dielectric layer are located in the trench, or both the first gate dielectric layer and the second gate dielectric layer are located outside the trench; and a first gate and a second gate that are spaced apart, where the first gate is disposed on a side that is of the first gate dielectric layer and that faces away from the channel, and the second gate is disposed on a side that is of the second gate dielectric layer and that faces away from the channel.

In this application, the first gate and the second gate are spaced apart, and the first gate and the second gate can be located in different orientations of the channel. Therefore, compared with that in a solution in which a vertical transistor includes only a first gate that is non-gate-all-around or includes only a second gate that is non-gate-all-around, the first gate and the second gate can perform gate control on the channel at different positions, which reduces leakage current of the channel.

In addition, the first gate and the second gate in this application are no longer in a surrounding shape, and the first gate dielectric layer and the second gate dielectric layer are no longer in a surrounding shape. Therefore, this application no longer first forms a first via in a gate-all-around and then forms a second via in a gate dielectric layer using a process in a related technology. Instead, a sacrificial structure (for example, a sacrificial layer or a dummy channel) is first formed in a region in which the to-be-formed channel is located, the trench is provided between adjacent sacrificial structures, and then the first gate dielectric layer, the second gate dielectric layer, the first gate, and the second gate are formed on a side wall of the sacrificial structure. Then, the sacrificial structure is removed, and the channel is formed at a position of the sacrificial structure, to enable the channel to be in contact with the first electrode. In other words, in this application, there is no need to form a second via between the first gate dielectric layer and the second gate dielectric layer. This can avoid a case in which a size of the vertical transistor cannot be scaled due to process limitation of forming the second via.

In addition, the first gate and the second gate are spaced apart, instead of being around the channel for one circle. Therefore, a total area of the first gate and the second gate is less than a total area of a gate in a gate-all-around solution. This reduces a size of the vertical transistor in the X direction and/or a size of the vertical transistor in the Y direction, and enables the vertical transistor to be scaled. Further, the first gate dielectric layer and the second gate dielectric layer that are configured to isolate the channel from the first gate and the second gate can also be spaced apart, instead of being around the channel for one cycle. Therefore, a total area of the first gate dielectric layer and the second gate dielectric layer in this application is less than a total area of a gate dielectric layer in the gate-all-around solution. This reduces the size of the vertical transistor in the X direction and/or the size of the vertical transistor in the Y direction, and enables the vertical transistor to be scaled. The Y direction may be a direction in which the first gate points to the second gate, and a Z direction may be a direction in which the first electrode points to the second electrode.

On this basis, due to the process limitation, a specific etching region (for example, about 20 nm space is reserved in the X direction and the Y direction) usually needs to be reserved for a process of providing a hole at a bottom of the gate dielectric layer. When a size of the second via is fixed, in embodiments of this application, the trench is provided in the channel. This can reduce thicknesses of the channel in the X direction and the Y direction, and improve a gate control capability of the vertical transistor.

In some possible implementations, both the first gate dielectric layer and the second gate dielectric layer are located outside the trench, the first gate is disposed on the side that is of the first gate dielectric layer and that faces away from the channel, and the second gate is disposed on the side that is of the second gate dielectric layer and that faces away from the channel.

In some possible implementations, the chip further includes a first insulation layer, and the first insulation layer is filled in the trench. This separates the first electrode from the second electrode via the first insulation layer. Alternatively, the trench further includes a bottom adjacent to and between side walls, the bottom is in contact with the first electrode, and the second electrode is filled in the trench.

A person skilled in the art should know that a region, in the channel, in which the first gate overlaps with the second gate and that is located between the first electrode and the second electrode is referred to as a channel region. However, a size of the channel region in the Z direction when the second electrode is filled in the trench is less than a size of the channel region in the Z direction when the first insulation layer is filled in the trench. Therefore, to ensure the gate control capability and avoid an excessively small size of the channel region in the Z direction, an overlapping size of the second electrode with the first gate and the second gate in the Z direction cannot be excessively large. For example, in this application, the overlapping size of the second electrode with the first gate and the second gate in the Z direction does not exceed 30 nm.

In some possible implementations, both the first gate dielectric layer and the second gate dielectric layer are located in the trench, the chip further includes a first insulation layer, and the first insulation layer is filled in the trench; and the first gate is disposed between the first gate dielectric layer and the first insulation layer, and the second gate is disposed between the second gate dielectric layer and the first insulation layer.

In some possible implementations, there are a plurality of vertical transistors; a plurality of vertical transistors arranged in a column direction share a same first electrode; and a plurality of vertical transistors arranged in a row direction share a same first gate and a same second gate.

In some possible implementations, when both the first gate dielectric layer and the second gate dielectric layer are located in the trench, channels of adjacent vertical transistors arranged in the column direction are connected.

In some possible implementations, the first gate and the second gate are disposed opposite to each other.

In some possible implementations, when both the first gate dielectric layer and the second gate dielectric layer are located outside the trench, a longitudinal cross section of the trench is U-shaped, or a transverse cross section of the trench is a closed loop; and the longitudinal cross section of the trench is an interface of the trench on a plane in which a first direction and a second direction are located, the first direction is a direction in which the first electrode points to the second electrode, and the second direction is a direction in which the first gate points to the second gate; and the transverse cross section of the trench is a cross section of the trench in the second direction.

According to a second aspect, this application provides a chip. The chip includes a vertical transistor, and the vertical transistor includes: a first electrode, a channel, and a second electrode that are sequentially stacked on a substrate, where the second electrode includes a first sub-electrode and a second sub-electrode that are disposed opposite to each other, and the channel includes a first channel located between the first electrode and the first sub-electrode and a second channel located between the first electrode and the second sub-electrode; a first gate dielectric layer and a second gate dielectric layer, where the first gate dielectric layer is in contact with a side wall of the first channel, and the second gate dielectric layer is in contact with a side wall of the second channel; and a first gate and a second gate that are disposed opposite to each other, where the first gate is disposed on a side that is of the first gate dielectric layer and that faces away from the first channel, and the second gate is disposed on a side that is of the second gate dielectric layer and that faces away from the second channel.

Compared with that in a related technology, in this application, one vertical transistor can be split into a first vertical transistor and a second vertical transistor, which can improve integration density. Compared with that in the dual-gate vertical transistor provided in the foregoing embodiment, in a direction in which the first vertical transistor points to the second vertical transistor, a spacing between a center of the first vertical transistor and a center of the second vertical transistor may be less than 30 nm, in other words, a pitch between the first vertical transistor and the second vertical transistor may be less than 30 nm. When being used in a DRAM, this application can implement a cell area smaller than those of advanced processes 1-beta and 1-gamma.

In addition, the first gate and the second gate in this application are no longer in a surrounding shape, and the first gate dielectric layer and the second gate dielectric layer are no longer in a surrounding shape. Therefore, this application no longer first forms a first via in a gate-all-around and then forms a second via in a gate dielectric layer using a process in a related technology. Instead, a sacrificial structure (for example, a sacrificial layer or a dummy channel) is first formed in a region in which the to-be-formed channel is located, the trench is provided between adjacent sacrificial structures, and then the first gate dielectric layer, the second gate dielectric layer, the first gate, and the second gate are formed on a side wall of the sacrificial structure. Then, the sacrificial structure is removed, and the channel is formed at a position of the sacrificial structure, to enable the channel to be in contact with the first electrode. In other words, in this application, there is no need to form a second via between the first gate dielectric layer and the second gate dielectric layer. This can avoid a case in which a size of the vertical transistor cannot be scaled due to process limitation of forming the second via.

In addition, the first gate and the second gate are disposed opposite to each other, instead of being disposed around the channel for one cycle as in the related technology. This can reduce sizes of the first vertical transistor and the second vertical transistor in the X direction and the Y direction, and enable the first vertical transistor and the second vertical transistor to be scaled. Further, the first gate dielectric layer and the second gate dielectric layer may also be disposed opposite to each other, instead of being around the channel for one cycle. Therefore, a total area of the first gate dielectric layer and the second gate dielectric layer in this application is less than a total area of a gate dielectric layer in a gate-all-around solution. This reduces the sizes of the vertical transistors in the X direction and/or the Y direction, and enables the vertical transistors to be scaled.

In some possible implementations, the first channel and the second channel enclose a trench, the chip further includes a first insulation layer, and the first insulation layer is filled in the trench.

In some possible implementations, both the first gate dielectric layer and the second gate dielectric layer are located outside the trench, the first gate is disposed on the side that is of the first gate dielectric layer and that faces away from the first channel, and the second gate is disposed on the side that is of the second gate dielectric layer and that faces away from the second channel; or both the first gate dielectric layer and the second gate dielectric layer are located in the trench, the first gate is disposed between the first gate dielectric layer and the first insulation layer, and the second gate is disposed between the second gate dielectric layer and the second insulation layer.

In some possible implementations, the first channel and the second channel are disconnected.

According to a third aspect, this application provides a memory. The memory includes a memory array, and the memory array includes the chip according to the first aspect or the second aspect; and the memory array further includes a capacitor, and the capacitor is electrically connected to a vertical transistor in the chip.

In some possible implementations, the memory array includes the chip according to the first aspect, and the memory array further includes a word line and a bit line; a gate of the vertical transistor is electrically connected to the word line, a first electrode is electrically connected to the bit line, and a second electrode is electrically connected to the capacitor; or the memory array includes the chip according to the second aspect, and the memory array further includes a write word line, a read word line, and a bit line; and a second gate is electrically connected to the write word line, a second sub-electrode is electrically connected to a first gate, a first sub-electrode is electrically connected to the read word line, and a first electrode is electrically connected to the bit line.

Any one of the third aspect and the implementations of the third aspect corresponds to any one of the first aspect, the second aspect, and the implementations of the first aspect and the second aspect. For technical effect corresponding to any one of the third aspect and the implementations of the third aspect, refer to the technical effect corresponding to any one of the first aspect, the second aspect, and the implementations of the first aspect and the second aspect. Details are not described herein again.

According to a fourth aspect, this application provides an electronic device. The electronic device includes a circuit board and the chip according to the first aspect, or the chip according to the second aspect, or the memory according to the third aspect, where the chip or the memory is disposed on the circuit board.

Any one of the fourth aspect and the implementations of the fourth aspect corresponds to any one of the first aspect, the second aspect, and the implementations of the first aspect and the second aspect. For technical effect corresponding to any one of the fourth aspect and the implementations of the fourth aspect, refer to the technical effect corresponding to any one of the first aspect, the second aspect, and the implementations of the first aspect and the second aspect. Details are not described herein again.

According to a fifth aspect, this application provides a fabrication method for a chip, including: forming a first electrode, a first sacrificial layer, a second insulation layer, and a third insulation layer on a substrate, where the first sacrificial layer covers a surface of a side that is of the first electrode and that faces away from the substrate; in a third direction, the second insulation layer is located between adjacent first electrodes and between adjacent first sacrificial layers; and in a second direction, the third insulation layer is located between the adjacent first electrodes and covers side walls of the first electrodes; forming a first gate dielectric layer, a second gate dielectric layer, a first gate, and a second gate on a side that is of the third insulation layer and that faces away from the substrate, where the first gate dielectric layer is located between the first gate and the second insulation layer, the second gate dielectric layer is located between the second gate and the second insulation layer, and the first gate and the second gate are spaced apart; removing the first sacrificial layer to form a recess, so as to expose the surface of the side that is of the first electrode and that faces away from the substrate, and sequentially filling the recess with a channel and a first insulation layer; and forming a second electrode on a side that is of the channel and the first insulation layer and that faces away from the substrate, where the second direction is perpendicular to the third direction, and both the second direction and the third direction are perpendicular to a first direction in which the first electrode points to the second electrode.

In this application, the first sacrificial layer and the second insulation layer are first formed, and trenches are provided between the adjacent first sacrificial layers and between the adjacent second insulation layers through etch-back. Then, the first gate dielectric layer, the second gate dielectric layer, the first gate, and the second gate are formed on side walls of the first sacrificial layer and the second insulation layer. Finally, the first sacrificial layer is removed, and the channel is formed at a position of the first sacrificial layer, to enable the channel to be in contact with the first electrode. In other words, in this application, there is no need to form a second via between the first gate dielectric layer and the second gate dielectric layer. This can avoid a case in which a size of the vertical transistor cannot be scaled due to process limitation of forming the second via.

In some possible implementations, the second electrode includes a first sub-electrode and a second sub-electrode that are disposed opposite to each other, and the channel includes a first channel and a second channel; and the first channel is located between the first electrode and the first sub-electrode, and the second channel is located between the first electrode and the second sub-electrode.

Any one of the fifth aspect and the implementations of the fifth aspect corresponds to any one of the first aspect, the second aspect, and the implementations of the first aspect and the second aspect. For technical effect corresponding to any one of the fifth aspect and the implementations of the fifth aspect, refer to the technical effect corresponding to any one of the first aspect, the second aspect, and the implementations of the first aspect and the second aspect. Details are not described herein again.

According to a sixth aspect, this application provides a fabrication method for a chip, including: forming a third sacrificial layer, a fifth insulation layer, and a first electrode on a substrate, where the third sacrificial layer has a hollow part, and the hollow part penetrates the third sacrificial layer; and the first electrode and the fifth insulation layer are filled in the hollow part, and a vertical distance from a surface of a side that is of the fifth insulation layer and that faces away from the substrate to the substrate is greater than a vertical distance from a surface of a side that is of the third sacrificial layer and that faces away from the substrate to the substrate; forming a first gate dielectric layer, a second gate dielectric layer, a first gate, and a second gate, where the first gate dielectric layer is located between the first gate and the fifth insulation layer, the second gate dielectric layer is located between the second gate and the fifth insulation layer, and the first gate and the second gate are spaced apart; removing the fifth insulation layer and forming a channel in the hollow part, where the channel includes a first channel and a second channel; and forming a second electrode on a side that is of the channel and that faces away from the substrate, where the second electrode includes a first sub-electrode and a second sub-electrode that are disposed opposite to each other, the first channel is located between the first electrode and the first sub-electrode, and the second channel is located between the first electrode and the second sub-electrode.

In this application, the fifth insulation layer is formed in a region of the to-be-formed channel. Then, the first gate dielectric layer, the second gate dielectric layer, the first gate, and the second gate are formed on a side wall of the fifth insulation layer. Finally, the fifth insulation layer is removed, and the channel is formed at a position of the fifth insulation layer, to enable the channel to be in contact with the first electrode. In other words, in this application, there is no need to form a second via between the first gate dielectric layer and the second gate dielectric layer. This can avoid a case in which a size of the vertical transistor cannot be scaled due to process limitation of forming the second via.

In some possible implementations, the first channel and the second channel enclose a trench; and before forming the second electrode on the side that is of the channel and that faces away from the substrate, the fabrication method further includes: filling the trench with a first insulation layer.

In some possible implementations, forming the third sacrificial layer, the fifth insulation layer, and the first electrode on the substrate includes: forming the third sacrificial layer and a fourth insulation layer on the substrate, where the hollow part penetrates the third sacrificial layer and the fourth insulation layer; sequentially filling the hollow part with the first electrode and the fifth insulation layer; and removing the fourth insulation layer.

Any one of the sixth aspect and the implementations of the sixth aspect corresponds to any one of the first aspect, the second aspect, and the implementations of the first aspect and the second aspect. For technical effect corresponding to any one of the sixth aspect and the implementations of the sixth aspect, refer to the technical effect corresponding to any one of the first aspect, the second aspect, and the implementations of the first aspect and the second aspect. Details are not described herein again.

According to a seventh aspect, this application provides a fabrication method for a chip, including: forming a first electrode and a fourth sacrificial layer on a substrate, where the fourth sacrificial layer is located on a side that is of the first electrode and that faces away from the substrate; respectively forming a first gate and a second gate on two sides of adjacent fourth sacrificial layers; and forming a first gate dielectric layer, a second gate dielectric layer, a channel, and a second electrode, where the channel is disposed on a side that is of the first gate dielectric layer and that faces away from the first gate and a side that is of the second gate dielectric layer and that faces away from the second gate, and the second electrode is located on a side that is of the channel and that faces away from the substrate.

In this application, the fourth sacrificial layer is formed in a region of the to-be-formed channel. Then, the first gate dielectric layer, the second gate dielectric layer, the first gate, and the second gate are formed on a side wall of the fourth sacrificial layer. Finally, the fourth sacrificial layer is removed, and the channel is formed at a position of the fourth sacrificial layer, to enable the channel to be in contact with the first electrode. In other words, in this application, there is no need to form a second via between the first gate dielectric layer and the second gate dielectric layer. This can avoid a case in which a size of the vertical transistor cannot be scaled due to process limitation of forming the second via.

In some possible implementations, forming the first gate dielectric layer, the second gate dielectric layer, and the channel includes: sequentially forming a gate dielectric layer and a dummy channel on the first gate and the second gate; performing etch-back on the dummy channel, where a retained dummy channel covers a side wall of the gate dielectric layer; removing, under protection of the dummy channel, a part that is of the gate dielectric layer and that is not covered by the dummy channel, to obtain the first gate dielectric layer and the second gate dielectric layer; and removing the dummy channel, and forming the channel on the side that is of the first gate dielectric layer and that faces away from the first gate and the side that is of the second gate dielectric layer and that faces away from the second gate.

Any one of the seventh aspect and the implementations of the seventh aspect corresponds to any one of the first aspect, the second aspect, and the implementations of the first aspect and the second aspect. For technical effect corresponding to any one of the seventh aspect and the implementations of the seventh aspect, refer to the technical effect corresponding to any one of the first aspect, the second aspect, and the implementations of the first aspect and the second aspect. Details are not described herein again.

### BRIEF DESCRIPTION OF DRAWINGS

FIG. 1 is a top view of a memory array according to a related technology;
FIG. 2a to FIG. 2d are diagrams of structures of a vertical transistor according to an embodiment of this application;
FIG. 2e is a top view of a vertical transistor according to an embodiment of this application;
FIG. 2f is a diagram of a structure of a channel according to an embodiment of this application;
FIG. 3a and FIG. 3b are diagrams of structures of a vertical transistor according to an embodiment of this application;
FIG. 4a is a diagram of a structure of a vertical transistor according to an embodiment of this application;
FIG. 4b is a diagram of a structure of a channel according to an embodiment of this application;
FIG. 5a is a diagram of a structure of a channel according to an embodiment of this application;
FIG. 5b and FIG. 5c are diagrams of structures of a vertical transistor according to an embodiment of this application;
FIG. 6 is a diagram of a structure of a vertical transistor according to an embodiment of this application;
FIG. 7a to FIG. 7e are diagrams of structures of a vertical transistor according to an embodiment of this application;
FIG. 8a to FIG. 8c are diagrams of structures of a vertical transistor according to an embodiment of this application;
FIG. 8d and FIG. 8e are top views of a vertical transistor according to an embodiment of this application;
FIG. 9a and FIG. 9b are diagrams of structures of a vertical transistor according to an embodiment of this application;
FIG. 10a to FIG. 10d are diagrams of structures of a memory cell according to an embodiment of this application;
FIG. 10e is a diagram of a circuit of the memory cell shown in FIG. 10d;
FIG. 11a is a top view of a memory cell according to an embodiment of this application;
FIG. 11b is a diagram of a circuit of the memory cell shown in FIG. 11a;
FIG. 12A to FIG. 12C are a flowchart of fabricating a chip according to an embodiment of this application;
FIG. 13a to FIG. 13f are three views in a process of fabricating a chip according to an embodiment of this application;
FIG. 14a to FIG. 14f are three views in a process of fabricating a chip according to an embodiment of this application;
FIG. 15a to FIG. 15g are three views in a process of fabricating a chip according to an embodiment of this application;
FIG. 16 is a flowchart of fabricating a chip according to an embodiment of this application;
FIG. 17a to FIG. 17k are three views in a process of fabricating a chip according to an embodiment of this application;
FIG. 18 is a flowchart of fabricating a chip according to an embodiment of this application; and
FIG. 19a to FIG. 19j are three views in a process of fabricating a chip according to an embodiment of this application.

### DESCRIPTION OF EMBODIMENTS

The following clearly and completely describes technical solutions in embodiments of this application with reference to accompanying drawings in embodiments of this application. It is clear that the described embodiments are a part but not all of embodiments of this application. All other embodiments obtained by a person of ordinary skill in the art based on embodiments of this application without creative efforts shall fall within the protection scope of this application.

The term "and/or" in this specification describes only an association relationship for associated objects and indicates that three relationships may exist. For example, A and/or B may indicate the following three cases: Only A exists, both A and B exist, and only B exists.

In the specification and claims in embodiments of this application, the terms "first", "second", and the like are intended to distinguish between different objects but do not indicate a particular order of the objects. For example, a first target object and a second target object are used to distinguish between different target objects, but are not used to describe a particular order of the target objects.

In embodiments of this application, the word "example" or "for example" is used to represent giving an example, an illustration, or a description. Any embodiment or design scheme described as an "example" or "for example" in embodiments of this application should not be explained as being more preferred or having more advantages than another embodiment or design scheme. To be precise, the words such as "example" or "for example" are intended to present a relative concept in a specific manner.

In descriptions of embodiments of this application, unless otherwise stated, "a plurality of" means two or more than two. For example, a plurality of processing units refer to two or more processing units, and a plurality of systems refer to two or more systems.

An embodiment of this application provides an electronic device. The electronic device may be a device including a memory, like a consumer electronic product, a home electronic product, a vehicle-mounted electronic product, a financial terminal product, or a communication electronic product.

The consumer electronic product is, for example, a mobile phone (mobile phone), a tablet computer (tablet computer), a notebook computer, a personal computer (personal computer, PC), a personal digital assistant (personal digital assistant, PDA), an intelligent wearable product (for example, a smart watch or a smart band), a virtual reality (virtual reality, VR) terminal device, an augmented reality (augmented reality, AR) terminal device, or an uncrewed aerial vehicle. The home electronic product is, for example, an intelligent lock, a television, a smart speaker, a refrigerator, or a floor sweeping robot. The vehicle-mounted electronic product is, for example, a vehicle-mounted navigator or a vehicle-mounted display. The financial terminal product is, for example, an automated teller machine (automated teller machine, ATM) or a self-service business handling terminal. The communication electronic product is, for example, a device including a chip, like a communication device, such as a server, a memory, a radar, or a base station.

For ease of description, the following uses an example in which the electronic device is a mobile phone for description. The mobile phone may include a processor. The processor includes a logic circuit and a memory. The memory includes a memory array, a memory controller, a decoder, and the like. The logic circuit may read and write data in the memory array via the memory controller and the decoder.

For example, the memory is a (dynamic random access memory, DRAM). DRAMs are widely used in electronic devices. Due to a capacitor structure used in a conventional DRAM, a scaling process of the DRAM is slower than that of a processor, and performance of the DRAM is lower than that of the processor. Consequently, it is gradually difficult to improve overall storage and computing performance of the electronic device.

In the conventional technology, a vertical transistor is used and the vertical transistor is integrated with the capacitor structure in a vertical direction, to implement a high-density memory cell. This holds promise for further scaling of the memory. In addition, the vertical transistor can also be used in a device other than the memory. This is not limited in embodiments of this application.

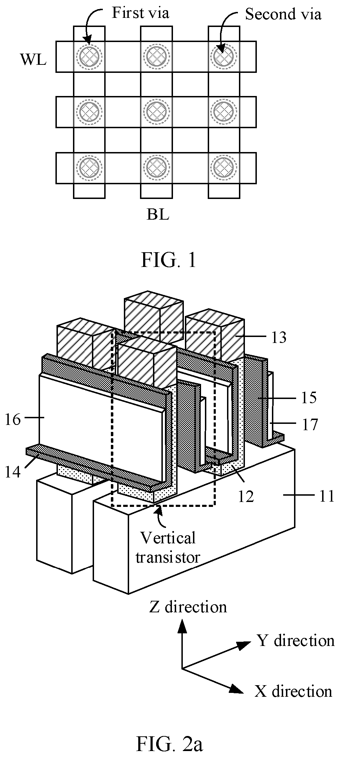

However, as shown in FIG. 1, a structure of a current mainstream vertical transistor is a gate-all-around structure. A first via needs to be provided in a gate, and a gate dielectric layer is first deposited in the first via. Then, a second via is provided at a bottom of the gate dielectric layer, and in the second via, a channel is formed and an etching region is reserved. On a plane (a plane on which XY directions are located) perpendicular to a vertical direction (Z direction), a size of a vertical transistor is affected by sizes of the gate, the gate dielectric layer, the channel, and the reserved etching region. As a result, one transistor occupies a large area, which is not conducive to scaling of the vertical transistor. In addition, after a hole is drilled in the gate dielectric layer to obtain the second via, the channel filled in the second via can be in contact with a bottom electrode only. However, due to process limitation, a size of the second via is large, which limits scaling of the vertical transistor.

For example, a total thickness of the gate in an X direction is about 10 nm, a total thickness of the gate dielectric layer in the X direction is about 10 nm, a diameter of the channel and the reserved etching region in the second via is 30 nm, and a spacing between adjacent transistors in the X direction is about 15 nm. In this way, a size occupied by the transistor in the X direction is about 65 nm. Based on this, an embodiment of this application provides a chip. The chip includes a vertical transistor, and a gate of the transistor includes a first gate and a second gate that are disposed opposite to each other. An area occupied by the gate is reduced, to implement scaling of the vertical transistor.

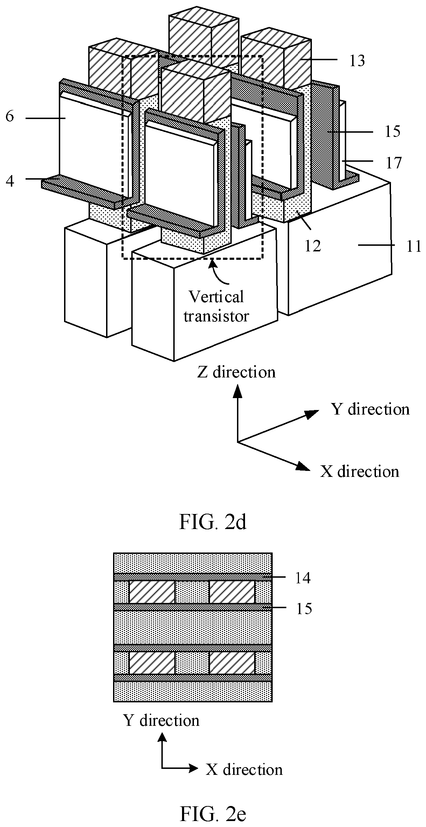

Specifically, as shown in FIG. 2a to FIG. 2d, the vertical transistor includes a first electrode 11, a channel 12, and a second electrode 13 that are sequentially stacked on a substrate 10. The channel 12 includes a trench. The first electrode 11 is a source and the second electrode 13 is a drain; or the first electrode 11 is a drain, and the second electrode 13 is a source. In this application, a direction in which the first electrode 11 points to the second electrode 13 may be the Z direction. In this specification, the Z direction is a first direction, a Y direction is a second direction, and the X direction is a third direction. The following uses the Z direction, the Y direction, and the X direction for description.

The vertical transistor further includes a first gate dielectric layer 14, a second gate dielectric layer 15, a first gate 16, and a second gate 17. Both the first gate dielectric layer 14 and the second gate dielectric layer 15 are in contact with a side wall of the trench. The first gate 16 is disposed on a side that is of the first gate dielectric layer 14 and that faces away from the channel 12, and the second gate 17 is disposed on a side that is of the second gate dielectric layer 15 and that faces away from the channel 12. In addition, the first gate 16 and the second gate 17 are spaced apart. In this way, the first gate dielectric layer 14 configured to isolate the first gate 16 from the channel 12 and the second gate dielectric layer 15 configured to isolate the second gate 17 from the channel 12 may also be spaced apart.

FIG. 2a shows 2×2 vertical transistors. The first electrode 11 may extend in the Y direction, and two vertical transistors arranged in the Y direction may share the first electrode 11. The first gate dielectric layer 14, the first gate 16, the second gate dielectric layer 15, and the second gate 17 may extend in the X direction, and two vertical transistors arranged in the X direction may share the first gate dielectric layer 14, the first gate 16, the second gate dielectric layer 15, and the second gate 17.

Certainly, as shown in FIG. 2d, a vertical transistor may alternatively include an independent first electrode 11, first gate dielectric layer 14, first gate 16, second gate dielectric layer 15, second gate 17, and second electrode 13. To be specific, a plurality of transistors arranged in the X direction or the Y direction do not share the first electrode 11, the first gate dielectric layer 14, the first gate 16, the second gate dielectric layer 15, the second gate 17, or the second electrode 13.

In some possible implementations, relative positions of the first gate 16 and the second gate 17 are not limited in embodiments of this application, provided that the first gate 16 and the second gate 17 are spaced apart. Optionally, the first gate 16 and the second gate 17 may be disposed opposite to each other. For ease of description, unless otherwise specified, the following uses an example in which the first gate 16 and the second gate 17 are disposed opposite to each other for description. In addition, a person skilled in the art should know that, in one vertical transistor, the first gate 16 and the second gate 17 may be electrically connected to jointly control the vertical transistor to be turned on or off. In other words, the vertical transistor in this embodiment of this application is a dual-gate vertical transistor.

In this application, the first gate 16 and the second gate 17 are spaced apart, and the first gate 16 and the second gate 17 can be located in different orientations of the channel 12. Therefore, compared with that in a solution in which a vertical transistor includes only a first gate 16 that is non-gate-all-around or includes only a second gate 17 that is non-gate-all-around, the first gate 16 and the second gate 17 can perform gate control on the channel 12 at different positions, which reduces leakage current of the channel 12.

In addition, the first gate 16 and the second gate 17 in this application are no longer in a surrounding shape, and the first gate dielectric layer 14 and the second gate dielectric layer 15 are no longer in a surrounding shape. Therefore, this application no longer first forms a first via in a gate-all-around and then forms a second via in a gate dielectric layer using a process in a related technology. Instead, a sacrificial structure (for example, a sacrificial layer or a dummy channel) is first formed in a region in which the to-be-formed channel 12 is located, the trench is provided between adjacent sacrificial structures, and then the first gate dielectric layer 14, the second gate dielectric layer 15, the first gate 16, and the second gate 17 are formed on a side wall of the sacrificial structure. Then, the sacrificial structure is removed, and the channel 12 is formed at a position of the sacrificial structure, to enable the channel 12 to be in contact with the first electrode 11. In other words, in this application, there is no need to form the second via between the first gate dielectric layer 14 and the second gate dielectric layer 15. This can avoid a case in which a size of the vertical transistor cannot be scaled due to process limitation of forming the second via.

In addition, the first gate 16 and the second gate 17 are spaced apart, instead of being around the channel 12 for one circle. Therefore, a total area of the first gate 16 and the second gate 17 is less than a total area of a gate in a gate-all-around solution. This reduces a size of the vertical transistor in the X direction and/or a size of the vertical transistor in the Y direction, and enables the vertical transistor to be scaled. Further, the first gate dielectric layer 14 and the second gate dielectric layer 15 that are configured to isolate the channel 12 from the first gate 16 and the second gate 17 can also be spaced apart, instead of being around the channel 12 for one cycle. Therefore, a total area of the first gate dielectric layer 14 and the second gate dielectric layer 15 in this application is less than a total area of a gate dielectric layer in the gate-all-around solution. This reduces the size of the vertical transistor in the X direction and/or the size of the vertical transistor in the Y direction, and enables the vertical transistor to be scaled.

On this basis, due to the process limitation, a specific etching region (for example, about 20 nm space is reserved in the X direction and the Y direction) usually needs to be reserved for a process of providing a hole at a bottom of the gate dielectric layer. When a size of the second via is fixed, in embodiments of this application, the trench is provided in the channel. This can reduce thicknesses of the channel 12 in the X direction and the Y direction, and improve a gate control capability of the vertical transistor.

In some possible implementations, the trench may include the side wall but does not include a bottom; or in addition to the side wall, the trench may further include a bottom adjacent to and between side walls. Certainly, in some other possible implementations, the channel 12 may not include the trench, but is of a solid overall structure, or the channel 12 is a hollow structure.

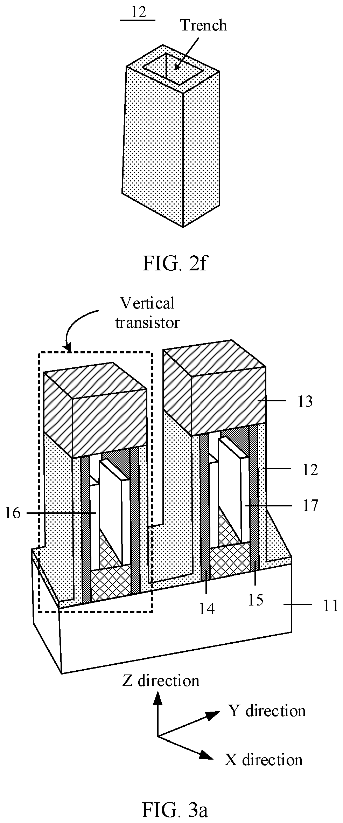

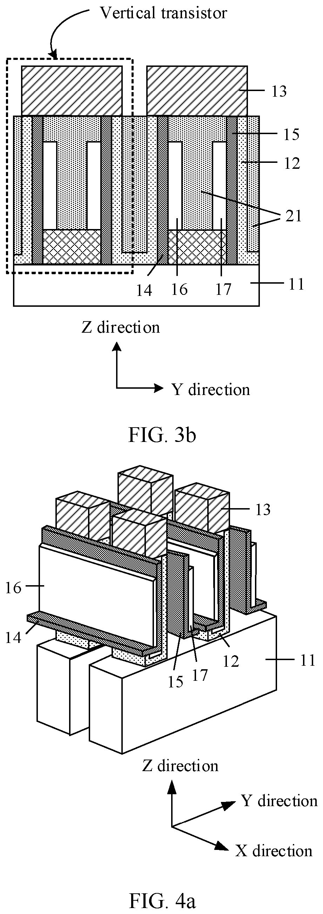

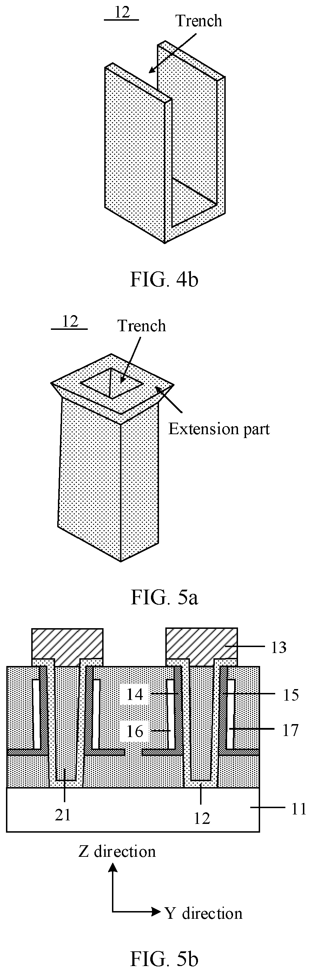

On this basis, a longitudinal cross section of the trench is U-shaped (FIG. 4a and FIG. 4b), or a transverse cross section of the trench is a closed loop (FIG. 2a and FIG. 2f). When the transverse cross section of the trench is the closed loop, the transverse cross section of the trench may be a closed-loop shape like a "square" (FIG. 2f), a circle, an ellipse, or the like. The longitudinal cross section of the trench is a cross section of the trench in the Z direction, and the transverse cross section of the trench is a cross section of the trench in a direction in which the first gate 16 points to the second gate 17.

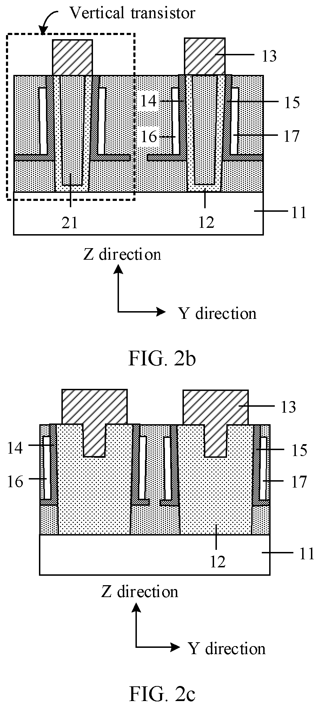

As shown in FIG. 2c, when the trench includes the bottom adjacent to the side wall, the second electrode 13 may be filled in the trench. The trench of the channel 12 includes the bottom, and therefore, the second electrode 13 is not directly in contact with the first electrode 11. Alternatively, as shown in FIG. 2b, regardless of whether the trench includes the bottom, the chip may further include a first insulation layer 21, and the first insulation layer 21 may be filled in the trench. This separates the first electrode 11 from the second electrode 13 via the first insulation layer 21.

A person skilled in the art should know that a region, in the channel 12, in which the first gate 16 overlaps with the second gate 17 and that is located between the first electrode 11 and the second electrode 13 is referred to as a channel region. However, a size of the channel region in the Z direction when the second electrode 13 is filled in the trench is less than a size of the channel region in the Z direction when the first insulation layer 21 is filled in the trench. Therefore, to ensure the gate control capability and avoid an excessively small size of the channel region in the Z direction, an overlapping size of the second electrode 13 with the first gate 16 and the second gate 17 in the Z direction cannot be excessively large. For example, in this application, the overlapping size of the second electrode 13 with the first gate 16 and the second gate 17 in the Z direction does not exceed 30 nm.

In some possible implementations, it is assumed that a surface that is of the side wall of the trench and that faces the first electrode 11 is a first surface, and a surface that is of the side wall of the trench and that faces the second electrode 13 is a second surface. Outside the trench, a surface adjacent to the first surface and the second surface in the trench is an outer side wall of the trench; and in the trench, a surface adjacent to the first surface and the second surface in the trench is an inner side wall of the trench.

As shown in FIG. 2a to FIG. 2e, both the first gate dielectric layer 14 and the second gate dielectric layer 15 may be located outside the trench, both the first gate dielectric layer 14 and the second gate dielectric layer 15 are in contact with the outer side walls of the trench, and the first gate 16 and the second gate 17 are also disposed outside the trench.

Alternatively, as shown in FIG. 3a and FIG. 3b, when the trench is filled with the first insulation layer 21, both the first gate dielectric layer 14 and the second gate dielectric layer 15 may be located in the trench, both the first gate dielectric layer 14 and the second gate dielectric layer 15 are in contact with the inner side wall of the trench, the first gate 16 and the second gate 17 are also disposed in the trench, and the first insulation layer 21 is disposed between the first gate 16 and the second gate 17. In this case, to prevent the trench from being in contact with the first gate 16 and the second gate 17, the trench of the channel 12 may not include the bottom.

As shown in FIG. 3a and FIG. 3b, when both the first gate 16 and the second gate 17 are located in the trench, in the direction in which the first gate 16 points to the second gate 17, channels 12 of adjacent vertical transistors are connected above the first electrode 11. Compared with that in a case in which channels 12 of adjacent vertical transistors are disconnected, in a case in which the channels 12 of the adjacent vertical transistors are connected above the first electrode 11, a contact area between the channels 12 and the first electrode 11 can be increased. In this case, a longitudinal cross section of a part, in the channel 12, located between the first gate dielectric layer 14 and the second gate dielectric layer 15 of the adjacent vertical transistor may be U-shaped.

In some possible implementations, as shown in FIG. 5a to FIG. 5c, the channel 12 further includes an extension part other than the trench, and the extension part is in contact with the second electrode 13. The extension part is connected to the side wall of the trench and extends outward, to increase the contact area between the channel 12 and the second electrode 13.

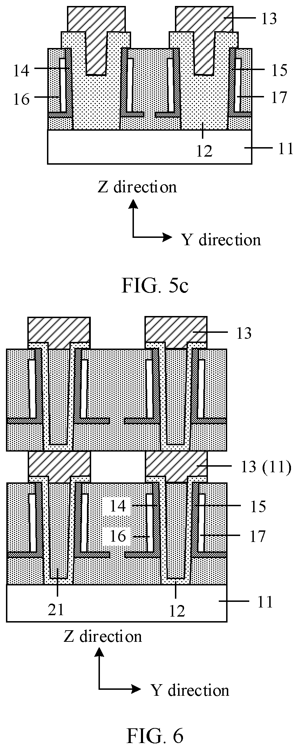

In addition, in some possible implementations, as shown in FIG. 5b and FIG. 5c, longitudinal cross sections of the first gate dielectric layer 14 and the second gate dielectric layer 15 may be L-shaped. The first gate dielectric layer 14 is located between the first gate 16 and the channel 12, and is also located between the first gate 16 and the first electrode 11. The second gate dielectric layer 15 is located between the second gate 17 and the channel 12, and is also located between the second gate 17 and the first electrode 11.

Based on this structure, sizes of structures in the vertical transistor are not limited in embodiments of this application.

Optionally, in the Z direction, a gate length (gate length) range of the first gate 16 and the second gate 17 may be 10 nm to 150 nm; a vertical distance range from the first gate 16 and the second gate 17 to the first electrode 11 may be 5 nm to 50 nm; and a vertical distance range from the first gate 16 and the second gate 17 to the second electrode 13 may be 5 nm to 50 nm.

For example, the first gate 16 and the second gate 17 are outside the trench. In the X direction or the Y direction, a total diameter range of the channel 12 may be 10 nm to 150 nm, a thickness range of the side wall of the channel 12 may be 1 nm to 15 nm, and a diameter of the trench does not exceed 148 nm. A thickness range of the first gate 16 and the second gate 17 may be 3 nm to 50 nm. A width range of the second electrode 13 may be 10 nm to 150 nm. A spacing range between centers of the adjacent vertical transistors may be 15 nm to 200 nm. A spacing range between centers of the channels 12 of the adjacent vertical transistors may be 15 nm to 200 nm.

In some possible implementations, the vertical transistors in this application may be independent isolated devices. To be specific, any vertical transistor does not share the first gate 16 with another vertical transistor on the chip, the any vertical transistor does not share the second gate 17 with the another vertical transistor on the chip, the any vertical transistor does not share the first electrode 11 with the another vertical transistor on the chip, and the any vertical transistor does not share the second electrode 13 with the another vertical transistor on the chip.

Alternatively, a plurality of vertical transistors in this application may form a connected array structure. For example, as shown in FIG. 3a, in the Y direction, the plurality of vertical transistors located in a same column share the same first electrode 11; and/or in the X direction, the plurality of vertical transistors located in a same row share the same first gate 16 and the same second gate 17.

In some possible implementations, as shown in FIG. 2a and FIG. 3a, the plurality of vertical transistors on the chip are not stacked in the Z direction; or, as shown in FIG. 6, the vertical transistors may be stacked in a plurality of layers in the Z direction.

Still refer to FIG. 6. When the vertical transistors are stacked in the plurality of layers in the Z direction, a second electrode 13 of a lower-layer vertical transistor may be reused as a first electrode 11 of an upper-layer vertical transistor. Certainly, the transistors stacked in the Z direction may be connected in another manner. This is not limited in embodiments of this application.

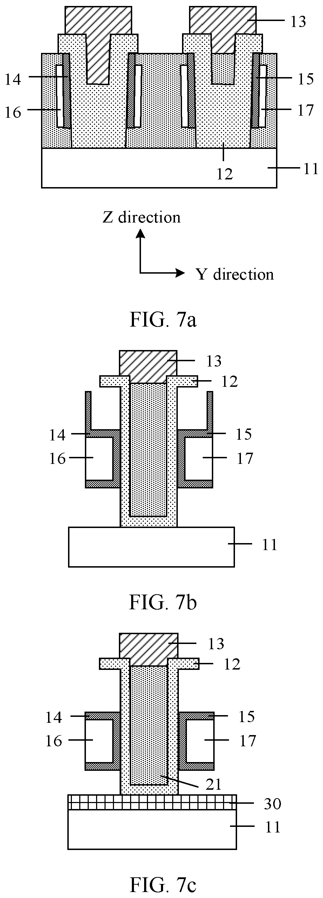

In addition, in addition to the L shapes, the longitudinal cross sections of the first gate dielectric layer 14 and the second gate dielectric layer 15 may be in other shapes. As shown in FIG. 7a, the longitudinal cross sections of the first gate dielectric layer 14 and the second gate dielectric layer 15 may alternatively be rectangular. The first gate dielectric layer 14 is located between the first gate 16 and the channel 12, and the second gate dielectric layer 15 is located between the second gate 17 and the channel 12. As shown in FIG. 7b, when both the first gate 16 and the second gate 17 are located on a side that is of the channel 12 and that faces away from the first insulation layer 21, the first gate dielectric layer 14 surrounds the first gate 16 and exposes a surface of a side that is of the first gate 16 and that faces away from the channel 12. On this basis, the first gate dielectric layer 14 may further extend towards the first electrode 11 and/or the second electrode 13 in the Z direction. The second gate dielectric layer 15 surrounds the second gate 17 and exposes a surface of a side that is of the second gate 17 and that faces away from the channel 12. On this basis, the second gate dielectric layer 15 may further extend towards the first electrode 11 and/or the second electrode 13 in the Z direction.

A process implementation of the structure may be as follows: First, dig a trench on a side of the foregoing sacrificial structure, then, form the first gate dielectric layer 14 and the second gate dielectric layer 15 laterally in the trench, and finally form the first gate 16 on the first gate dielectric layer 14 and form the second gate 17 on the second gate dielectric layer 15. A trench digging process is more controllable and process precision is high. Therefore, gate lengths of the first gate 16 and the second gate 17 filled in the trench are more controllable.

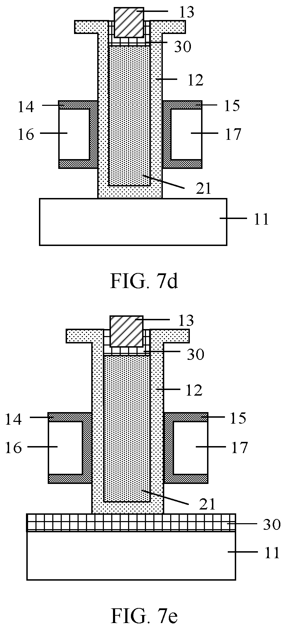

In some possible implementations, a buffer layer may be further included between the first electrode 11 and the channel 12 and/or a buffer layer may be further included between the second electrode 13 and the channel 12. As shown in FIG. 7c, the buffer layer 30 is disposed between the first electrode 11 and the channel 12. As shown in FIG. 7d, the buffer layer 30 is disposed between the second electrode 13 and the channel 12. As shown in FIG. 7e, the buffer layer 30 is disposed between the first electrode 11 and the channel 12 and between the second electrode 13 and the channel 12.

In some possible implementations, materials of the structures in the vertical transistor are not limited in embodiments of this application.

Optionally, the channel 12 may be made of an oxide semiconductor material deposited using a deposition process like atomic layer deposition (atomic layer deposition, ALD). A material of the channel 12 may include elements such as indium (In), gallium (Ga), zinc (Zn), tin (Sn), tungsten (W), magnesium (Mg), aluminum (Al), and silicon (Si), for example, indium gallium zinc oxide (InGaZnO), indium tin oxide (InSnO), indium gallium oxide (InGaO), and indium magnesium oxide (InMgO). Using the oxide semiconductor material as the material of the channel 12 can reduce leakage current of the vertical transistor. In a scenario in which the vertical transistor is used in a memory, retention (retention) time of the memory can be further increased, power consumption of the memory can be reduced, an area of a capacitor in the memory can be reduced, and therefore integration density is improved.

Certainly, the material of the channel 12 in this application may alternatively be an amorphous-structured material, and a partially crystallized-structured material, and include another semiconductor material, or the like, for example, polycrystalline silicon poly-Si, amorphous silicon a-Si, or a two-dimensional material.

Materials of the first gate dielectric layer 14 and the second gate dielectric layer 15 may include an oxide dielectric material, for example, hafnium oxide (HfO₂), aluminum oxide (Al₂O₃), silicon oxide (SiO₂), or hafnium silicon oxide (HfSiO), or may be nitrides such as silicon nitride (SiN). Alternatively, materials of the first gate dielectric layer 14 and the second gate dielectric layer 15 may include HfO₂ and Al₂O₃.

Both the first gate 16 and the second gate 17 may be single layers, or both the first gate 16 and the second gate 17 may be laminated layers. For example, both the first gate 16 and the second gate 17 are single layers. Materials of the first gate 16 and the second gate 17 may include a metal such as tungsten (W), ruthenium (Ru), nickel (Ni), and molybdenum (Mo), or an alloy material like platinum-nickel (NiPt). Alternatively, materials of the first gate 16 and the second gate 17 may be conductive oxides/nitrides, such as InSnO, titanium nitride (TiN), and tantalum nitride (TaN). For example, both the first gate 16 and the second gate 17 are laminated layers. Both the first gate 16 and the second gate 17 may be laminated layers of TaN and W. A layer at which TaN is located is located between a layer at which W is located and the first gate dielectric layer 14/the second gate dielectric layer 15.

Materials of the first electrode 11 and the second electrode 13 may include a metal, a nitride, or an alloy electrode, for example, W, Ni, Mo, Ru, NiPt, or TiN. Alternatively, materials of the first electrode 11 and the second electrode 13 may be conductive oxides, for example, InSnO.

A material of the first insulation layer 21 may be an oxide, a nitride, a carbon oxide, or the like, for example, silicon oxide (SiO), SiN, silicon carbon oxide (SiOC), or aluminum oxide (AlO).

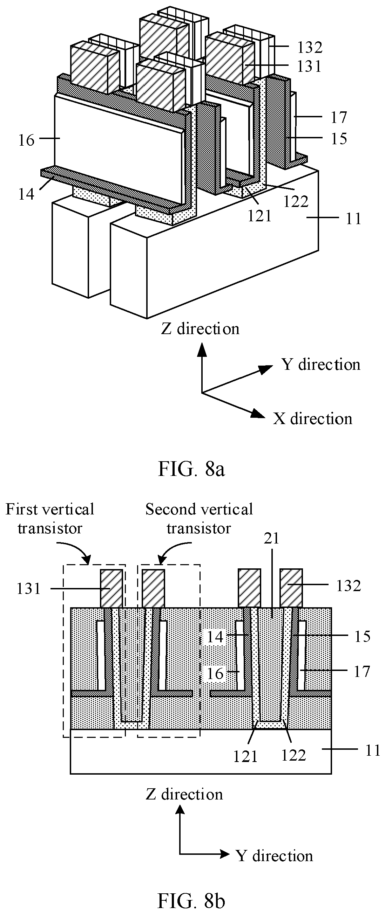

In another embodiment, as shown in FIG. 8a to FIG. 9b, an embodiment of this application further provides a chip. The chip includes a vertical transistor, and the vertical transistor includes a first electrode 11, a channel 12, and a second electrode 13 that are sequentially stacked. The second electrode 13 includes a first sub-electrode 131 and a second sub-electrode 132 that are disposed opposite to each other. For example, the first electrode 11 is a source, the second electrode 13 is a drain, the first sub-electrode 131 is a first drain, and the second sub-electrode 132 is a second drain. Alternatively, the first electrode 11 is a drain, the second electrode 13 is a source, the first sub-electrode 131 is a first source, and the second sub-electrode 132 is a second source. In this application, a direction in which the first electrode 11 points to the second electrode 13 may be a Z direction.

The chip further includes a first gate dielectric layer 14 and a second gate dielectric layer 15, and both the first gate dielectric layer 14 and the second gate dielectric layer are in contact with side walls of the channel. A part that is of the channel 12 and that is in contact with the first gate dielectric layer 14 is referred to as a first channel 121, and the first channel 121 is located between the first electrode 11 and the first sub-electrode 131. A part that is of the channel 12 and that is in contact with the second gate dielectric layer 15 is referred to as a second channel 122, and the second channel 122 is located between the first electrode 11 and the second sub-electrode 132.

The chip further includes a first gate 16 and a second gate 17 that are disposed opposite to each other. The first gate 16 is disposed on a side that is of the first gate dielectric layer 14 and that faces away from the channel 12, and the second gate 17 is disposed on a side that is of the second gate dielectric layer 15 and that faces away from the channel 12. In addition, the first gate 16 and the second gate 17 are disposed opposite to each other. In this way, the first gate dielectric layer 14 configured to isolate the first gate 16 from the channel 12 and the second gate dielectric layer 15 configured to isolate the second gate 17 from the channel 12 may also be disposed opposite to each other.

Vertical transistors that can be obtained from the foregoing structure are respectively a first vertical transistor and a second vertical transistor. The first vertical transistor includes the first electrode 11, the first channel 121, the first sub-electrode 131, the first gate dielectric layer 14, and the first gate 16. The second vertical transistor includes the first electrode 11, the second channel 122, the second sub-electrode 132, the second gate dielectric layer 15, and the second gate 17. As in the foregoing embodiment, the first vertical transistor shares the first electrode 11 with the second vertical transistor, or the first vertical transistor may not share the first electrode 11 with the second vertical transistor. The first gate 16 is configured to control the first vertical transistor to be turned on or off, and the second gate 17 is configured to control the second vertical transistor to be turned on or off. In other words, both the first vertical transistor and the second vertical transistor in embodiments of this application are single-gate vertical transistors.

Compared with that in a related technology, in this application, one vertical transistor can be split into a first vertical transistor and a second vertical transistor, which can improve integration density. Compared with that in the dual-gate vertical transistor provided in the foregoing embodiment, in a direction in which the first vertical transistor points to the second vertical transistor, a spacing between a center of the first vertical transistor and a center of the second vertical transistor may be less than 30 nm, in other words, a pitch between the first vertical transistor and the second vertical transistor may be less than 30 nm. When being used in a DRAM, this application can implement a cell area smaller than those of advanced processes 1-beta and 1-gamma.

In addition, the first gate 16 and the second gate 17 in this application are no longer in a surrounding shape, and the first gate dielectric layer 14 and the second gate dielectric layer 15 are no longer in a surrounding shape. Therefore, this application no longer first forms a first via in a gate-all-around and then forms a second via in a gate dielectric layer using a process in a related technology. Instead, a sacrificial structure (for example, a sacrificial layer or a dummy channel) is first formed in a region in which the to-be-formed channel 12 is located, the trench is provided between adjacent sacrificial structures, and then the first gate dielectric layer 14, the second gate dielectric layer 15, the first gate 16, and the second gate 17 are formed on a side wall of the sacrificial structure. Then, the sacrificial structure is removed, and the channel 12 is formed at a position of the sacrificial structure, to enable the channel 12 to be in contact with the first electrode 11. In other words, in this application, there is no need to form the second via between the first gate dielectric layer 14 and the second gate dielectric layer 14. This can avoid a case in which a size of the vertical transistor cannot be scaled due to process limitation of forming the second via.

In addition, the first gate 16 and the second gate 17 are disposed opposite to each other, instead of being disposed around the channel 12 for one cycle as in the related technology. This can reduce sizes of the first vertical transistor and the second vertical transistor in an X direction and a Y direction, and enable the first vertical transistor and the second vertical transistor to be scaled. Further, the first gate dielectric layer 14 and the second gate dielectric layer 15 may also be disposed opposite to each other, instead of being around the channel 12 for one cycle. Therefore, a total area of the first gate dielectric layer 14 and the second gate dielectric layer 15 in this application is less than a total area of a gate dielectric layer in a gate-all-around solution. This reduces the sizes of the vertical transistors in the X direction and/or the Y direction, and enables the vertical transistors to be scaled.

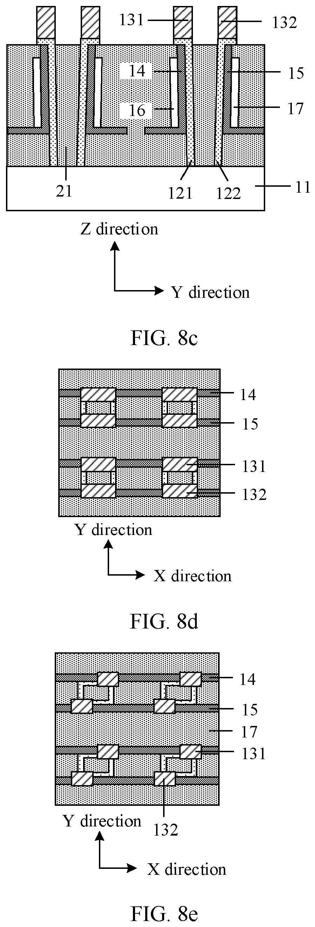

In some possible implementations, relative positions of the first sub-electrode 131 and the second sub-electrode 132 are not limited in embodiments of this application, provided that the first sub-electrode 131 and the second sub-electrode 132 are disposed opposite to each other. Optionally, as shown in FIG. 8d, the first sub-electrode 131 and the second sub-electrode 132 are disposed opposite to each other in the X direction or the Y direction. Alternatively, as shown in FIG. 8e, the first sub-electrode 131 and the second sub-electrode 132 may not be completely disposed opposite to each other in the X direction or the Y direction on the basis of being disposed opposite to each other.

Similarly, relative positions of the first gate 16 and the second gate 17 are not limited in embodiments of this application, provided that the first gate 16 and the second gate 17 are disposed opposite to each other. Optionally, the first sub-electrode 131 and the second sub-electrode 132 are disposed opposite to each other in the X direction or the Y direction. Alternatively, the first gate 16 and the second gate 17 may not be completely disposed opposite to each other in the X direction or the Y direction on the basis of being disposed opposite to each other.

For ease of description, unless otherwise specified, the following uses an example in which the first sub-electrode 131 and the second sub-electrode 132 are directly opposite in the Y direction, and the first gate 16 and the second gate 17 are disposed opposite to each other in the Y direction for description.

In some possible implementations, as shown in FIG. 8b, the first vertical transistor shares the first electrode 11 with the second vertical transistor. Therefore, the first channel 121 and the second channel 122 can be connected, and a short circuit does not occur. Alternatively, as shown in FIG. 8c, the first channel 121 and the second channel 122 can alternatively be disconnected. Compared with that in a solution in which the first channel 121 and the second channel 122 are disconnected, in a solution in which the first channel 121 and the second channel 122 are connected, the first channel 121 and the second channel 122 do not need to be etched and disconnected, and a process is simple. Compared with the solution in which the first channel 121 and the second channel 122 are connected, the solution in which the first channel 121 and the second channel 122 are disconnected not only can improve crosstalk between the first vertical transistor and the second vertical transistor caused by a connection between the first channel 121 and the second channel 122, but also facilitates fabrication of the first vertical transistor and the second vertical transistor that are not connected.

When the first channel 121 and the second channel 122 are connected, as shown in FIG. 8a, the first channel 121 and the second channel 122 form a solid overall structure or a hollow structure. Alternatively, refer to FIG. 2f, the first channel 121 and the second channel 122 form a trench with a bottom, or in other words, a trench that includes a bottom is provided in the channel 12. A transverse cross section of the trench is a closed loop, for example, the transverse cross section of the trench may be a closed-loop shape like a "square", a circle, an ellipse, or the like. Alternatively, as shown in FIG. 4a and FIG. 4b, a longitudinal cross section of the trench is U-shaped.

As shown in FIG. 8c, when the first channel 121 and the second channel 122 are disconnected, both the first channel 121 and the second channel 122 may be independent columnar shapes, and the columnar first channel 121 and the columnar second channel 122 form a trench without a bottom, or in other words, a trench that does not include a bottom is provided in the channel 12.

When the first channel 121 and the second channel 122 form the trench, and the trench has the bottom, the second electrode 13 may be filled in the trench. The trench of the channel 12 includes the bottom, and therefore, the second electrode 13 is not directly in contact with the first electrode 11. Alternatively, as shown in FIG. 8b and FIG. 8c, regardless of whether the trench includes the bottom, the chip may further include a first insulation layer 21, and the first insulation layer 21 may be filled in the trench. This separates the first electrode 11 from the second electrode 13 via the first insulation layer 21.

In some possible implementations, it is assumed that a surface that is of the trench and that faces the first electrode 11 is a first surface, and a surface that is of the trench and that faces the second electrode 13 is a second surface. Outside the trench, a surface adjacent to the first surface and the second surface in the trench is an outer side wall of the trench; and in the trench, a surface adjacent to the second surface and a bottom surface of the trench is an inner side wall of the trench.

As shown in FIG. 8a to FIG. 8c, both the first gate dielectric layer 14 and the second gate dielectric layer 15 may be located outside the trench, both the first gate dielectric layer 14 and the second gate dielectric layer 15 are in contact with the outer side walls of the trench, and the first gate 16 and the second gate 17 are also disposed outside the trench.

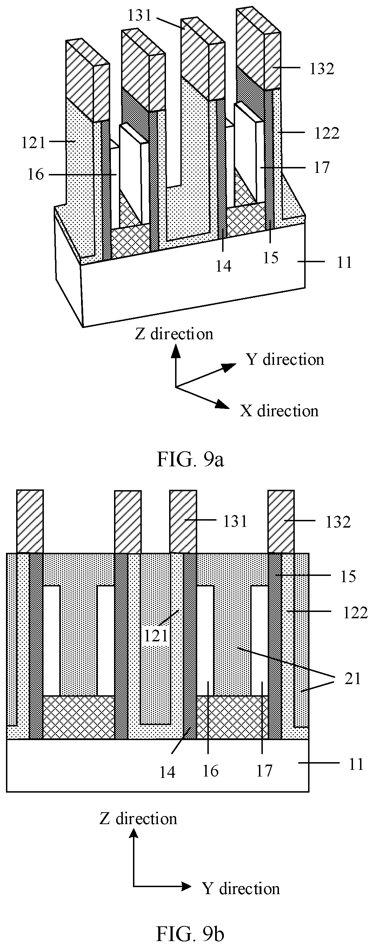

Alternatively, as shown in FIG. 9a and FIG. 9b, when the trench is filled with the first insulation layer 21, both the first gate dielectric layer 14 and the second gate dielectric layer 15 may be located in the trench, both the first gate dielectric layer 14 and the second gate dielectric layer 15 are in contact with the inner side wall of the trench, the first gate 16 and the second gate 17 are also disposed in the trench, and the first insulation layer 21 is disposed between the first gate 16 and the second gate 17. In this case, to prevent the trench from being in contact with the first gate 16 and the second gate 17, the trench of the channel 12 may not include the bottom.

As shown in FIG. 9a and FIG. 9b, when both the first gate 16 and the second gate 17 are located in the trench, in the direction in which the first gate 16 points to the second gate 17, channels 12 of adjacent vertical transistors are connected above the first electrode 11. Compared with that in a case in which channels 12 of adjacent vertical transistors are disconnected, in a case in which the channels 12 of the adjacent vertical transistors are connected above the first electrode 11, a contact area between the channels 12 and the first electrode 11 can be increased. In this case, a longitudinal cross section of a part, in the channel 12, located between the first gate dielectric layer 14 and the second gate dielectric layer 15 of the adjacent vertical transistor may be U-shaped.

As shown in FIG. 8c, the channel 12 further includes an extension part other than the trench, and the extension part is in contact with the second electrode 13. The extension part is connected to the side wall of the trench and extends outward, to increase the contact area between the channel 12 and the second electrode 13. For example, a longitudinal cross section of the channel 12 is U-shaped. An extension part of the first channel 121 extends to a side that is away from the second channel 122, and an extension part of the second channel 122 extends to a side that is away from the first channel 121.

On this basis, as shown in FIG. 8b and FIG. 8c, longitudinal cross sections of the first gate dielectric layer 14 and the second gate dielectric layer 15 may be L-shaped. The first gate dielectric layer 14 is located between the first gate 16 and the channel 12, and is also located between the first gate 16 and the first electrode 11. The second gate dielectric layer 15 is located between the second gate 17 and the channel 12, and is also located between the second gate 17 and the first electrode 11.

In addition, for sizes, materials, and the like of the structures in the chip in this embodiment of this application, refer to the sizes, materials, and the like of the structures in the chip in the foregoing embodiment. Details are not described in this embodiment of this application.

The vertical transistors provided in the foregoing two embodiments may be used in a memory. The memory includes a memory array, the memory array includes a memory cell, and the memory cell includes at least one vertical transistor and at least one capacitor. The capacitor includes a first electrode 41, a second electrode 42, and a dielectric layer located between the first electrode 41 and the second electrode 42.

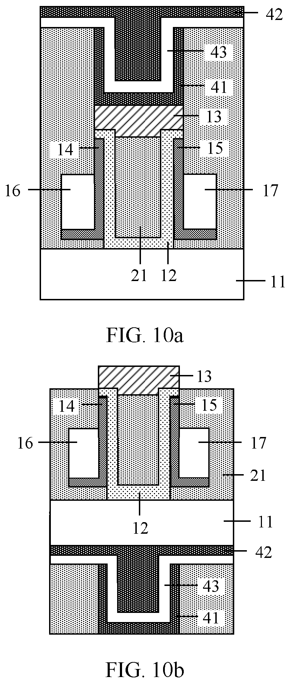

As shown in FIG. 10a, the capacitor is disposed above the vertical transistor, and the first electrode 41 of the capacitor is electrically connected to the second electrode 13 of the vertical transistor.

As shown in FIG. 10b, the capacitor is disposed below the vertical transistor, and the first electrode 41 of the capacitor is electrically connected to the first electrode 11 of the vertical transistor.

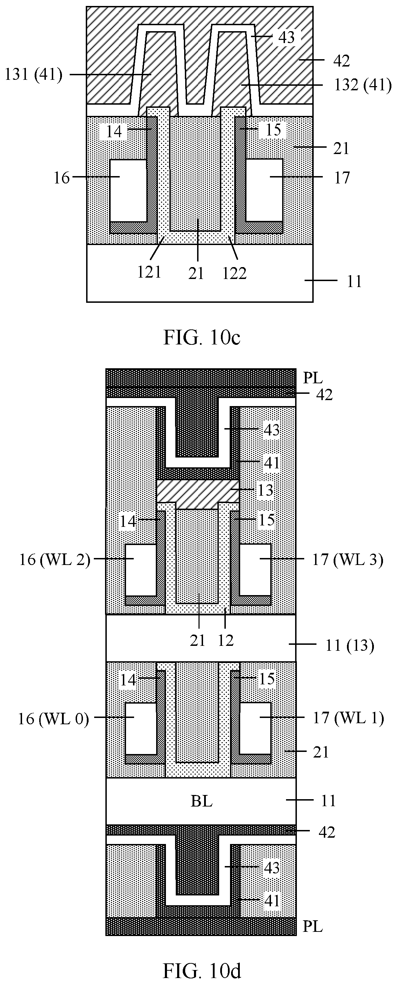

As shown in FIG. 10c, the capacitor is disposed above the vertical transistor, and the first electrode 41 of the capacitor is also reused as the second electrode 13 of the vertical transistor, to form a structure in which the capacitor wraps the vertical transistor.

As shown in FIG. 10d, single-gate vertical transistors are stacked in a plurality of layers in a Z direction, the capacitor is further disposed above or below each vertical transistor, and the second electrode 42 of the capacitor is electrically connected to the second electrode 13 of the vertical transistor. As shown in FIG. 10d, an example in which two vertical transistors are stacked in the Z direction is used. A capacitor, a vertical transistor, a vertical transistor, and a capacitor are sequentially stacked in the Z direction. The second electrode 13 of the vertical transistor located below is shared as the first electrode 11 of the vertical transistor located above.

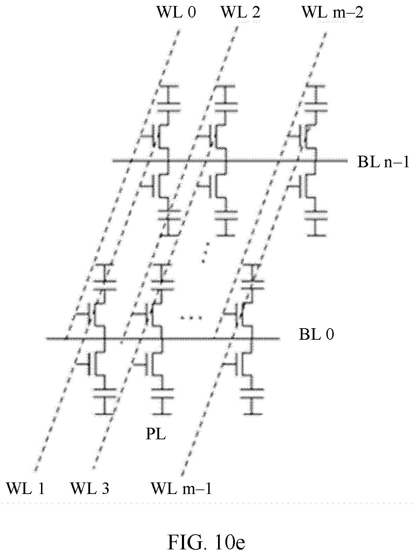

The vertical transistors and the capacitors shown in FIG. 10d may be applicable to a diagram of a circuit shown in FIG. 10e. FIG. 10e shows the diagram of the circuit of a memory. Any memory cell in the memory is 1T1C, namely, one vertical transistor and one capacitor. In FIG. 10e, a same bit line BL shared is located between the two rows of memory cells. Corresponding to a diagram of a structure shown in FIG. 10d, the memory includes n columns of bit lines BL and m rows of word lines WL, and memory cells on two sides of a bit line BL are controlled by different word lines WL.

In the figure, four rows of memory cells corresponding to a same column are shown, which respectively correspond to a word line WL0 to a word line WL3. This structure doubles density of the memory. In addition, two rows of memory cells share a same bit line BL, and therefore, only one layer of bit line BL needs to be manufactured between the two rows of memory cells. This reduces a quantity of mask (mask) templates and improves a capacity/cost ratio.

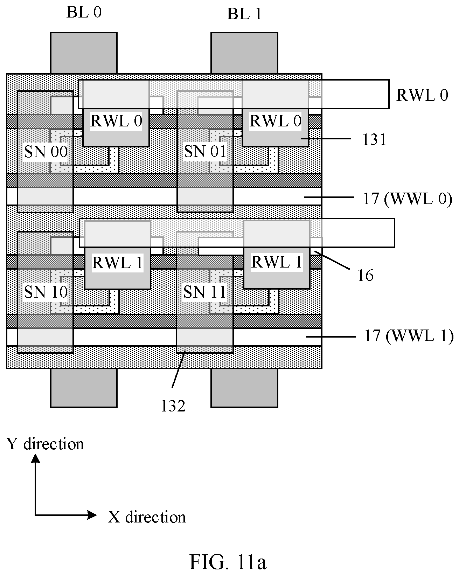

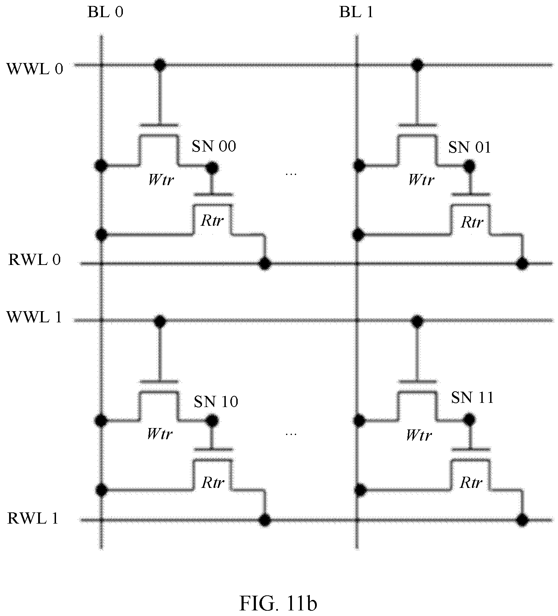

In some possible implementations, in addition to being applicable to the 1T1C memory cell, this embodiment of this application is further applicable to a 2T0C memory cell. FIG. 11a and FIG. 11b are top views of the 2T0C memory cell. The memory cell includes a first single-gate vertical transistor and a second single-gate vertical transistor. The first vertical transistor and the second vertical transistor share a first electrode 11 and are electrically connected to a bit line BL. In addition, a second sub-electrode 132 of the second vertical transistor and a first gate 16 of the first vertical transistor are further electrically connected at a node SN (for example, SN 00 in FIG. 11a). In addition, a second gate is electrically connected to a write word line WWL in a memory array, and the first sub-electrode 131 is electrically connected to a read word line RWL.

It should be understood that, to reflect that the second sub-electrode 132 of the second vertical transistor and the first gate 16 of the first vertical transistor are further electrically connected at the node SN, the first gate 16 and the second gate 17 can be seen in a top view shown in FIG. 11a. However, in an actual structure, the first gate 16 and the second gate 17 should be blocked by an insulation material, the first gate is electrically connected to the second sub-electrode 132 through a via in the insulation material, and the second gate is electrically isolated from the second sub-electrode 132 by using the insulation material.

Compared with a memory cell that requires an RBL (read BL) and a WBL (write BL), this structure of a circuit reduces one bit line, is simpler in a winding structure, occupies a smaller area, and can implement higher array density.

A feature of this structure is that the second vertical transistor is used as a write transistor (write FET, Wtr) in the 2T0C memory cell, and the first vertical transistor is used as a read transistor (read FET, Rtr) in the 2T0C memory cell. Because the first gate SN of the read FET is an independent electrode, the first gates 16 that are originally interconnected by a plurality of first vertical transistors in a same row on an Rtr side is a separated independent gate in the 2T0C, and the second gates 17 of a plurality of second vertical transistors in a same row on a Wtr side are still in a connected state.

Certainly, the vertical transistor and the capacitor in the memory cell may alternatively be disposed and electrically connected in another manner. This is not limited in embodiments of this application.

In still another embodiment, an embodiment of this application further provides a fabrication method for a chip. As described in the foregoing embodiment, vertical transistors on the chip may be classified into a dual-gate vertical transistor and a single-gate vertical transistor. The following separately describes, with reference to the accompanying drawings, fabrication processes of the chip on which the dual-gate vertical transistor and the single-gate vertical transistor are disposed.

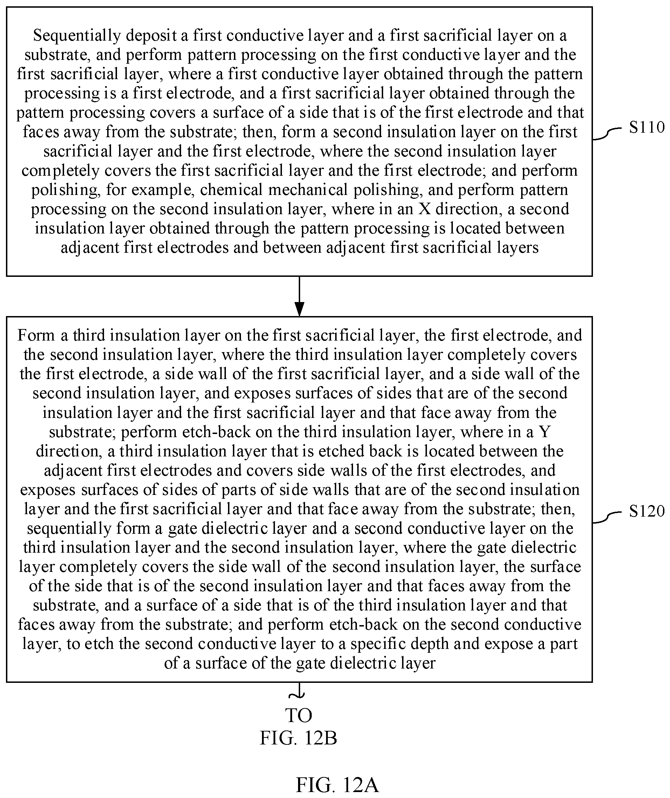

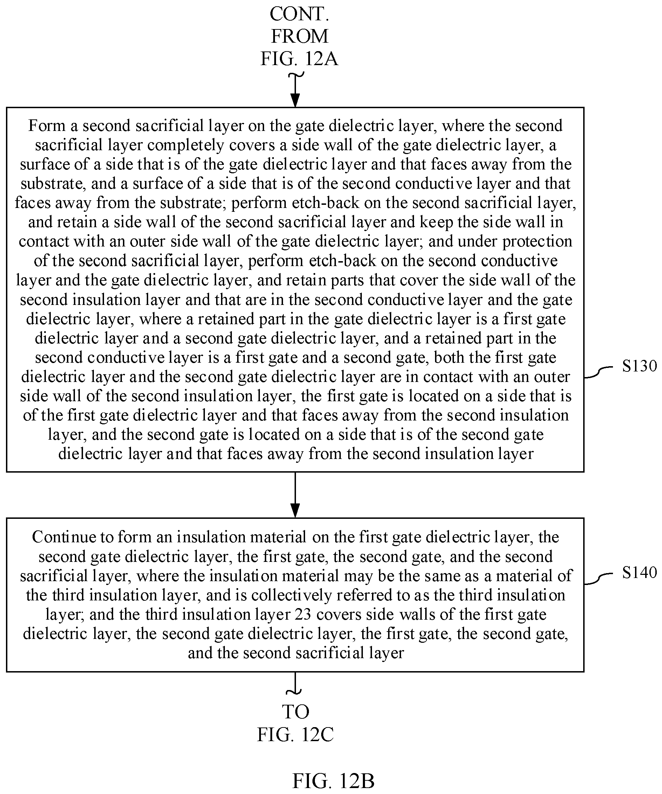

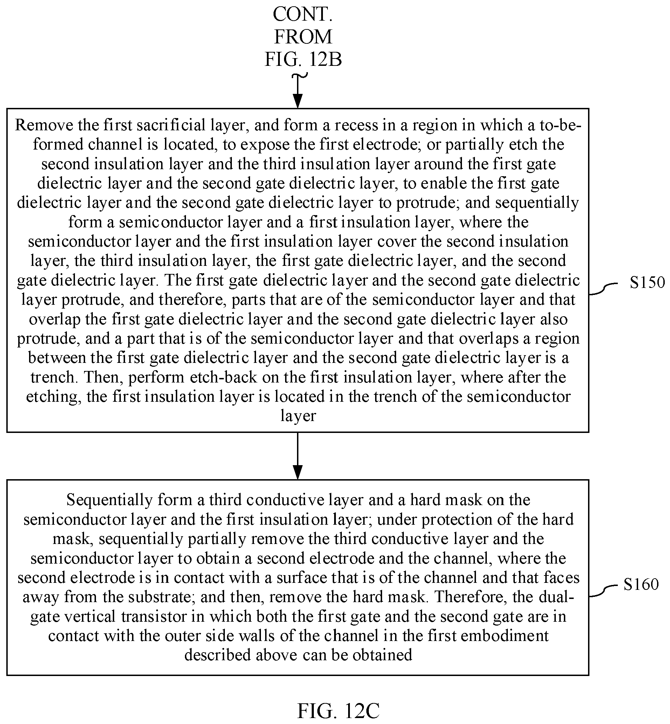

In a first case, both a first gate 16 and a second gate 17 are in contact with outer side walls of a channel 12, and a vertical transistor on the chip is a dual-gate vertical transistor. As shown in FIG. 12A to FIG. 12C, the structure may be implemented by the following steps.

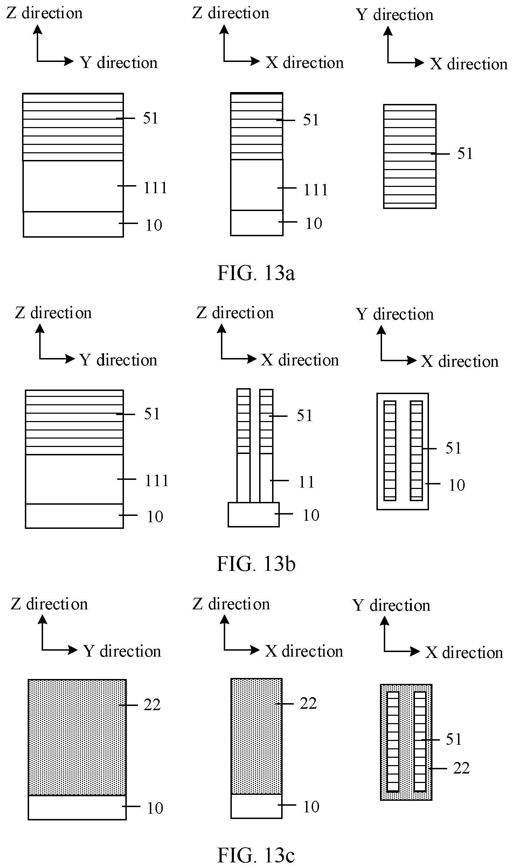

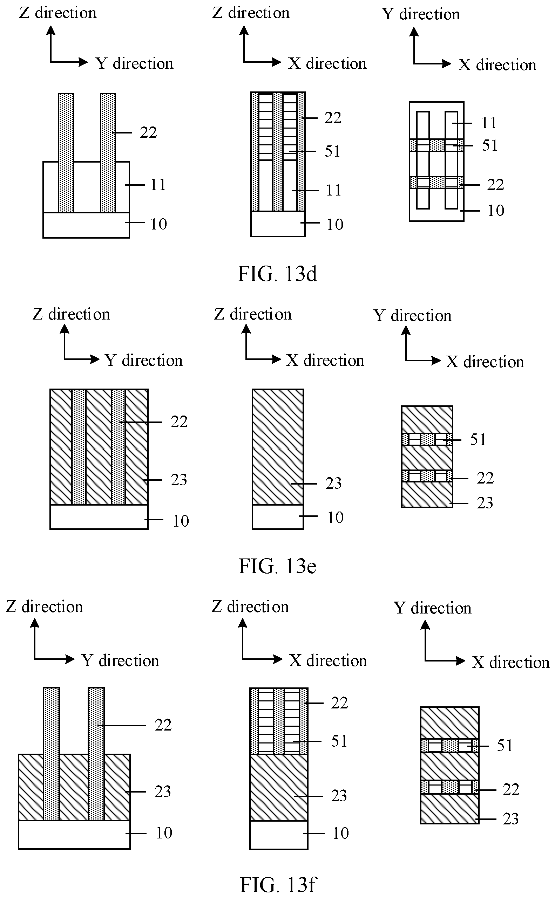

S110: As shown in FIG. 13a, sequentially deposit a first conductive layer 111 and a first sacrificial layer 51 on a substrate 10, and as shown in FIG. 13b, perform pattern processing on the first conductive layer 111 and the first sacrificial layer 51, where a first conductive layer 111 obtained through the pattern processing is a first electrode 11, and a first sacrificial layer obtained through the pattern processing covers a surface of a side that is of the first electrode 11 and that faces away from the substrate 10; then, as shown in FIG. 13c, form a second insulation layer 22 on the first sacrificial layer 51 and the first electrode 11, where the second insulation layer 22 completely covers the first sacrificial layer 51 and the first electrode 11; and perform polishing, for example, chemical mechanical polishing (chemical mechanical polishing, CMP), and as shown in FIG. 13d, perform pattern processing on the second insulation layer 22, where in an X direction, a second insulation layer 22 obtained through the pattern processing is located between adjacent first electrodes 11 and between adjacent first sacrificial layers 51.

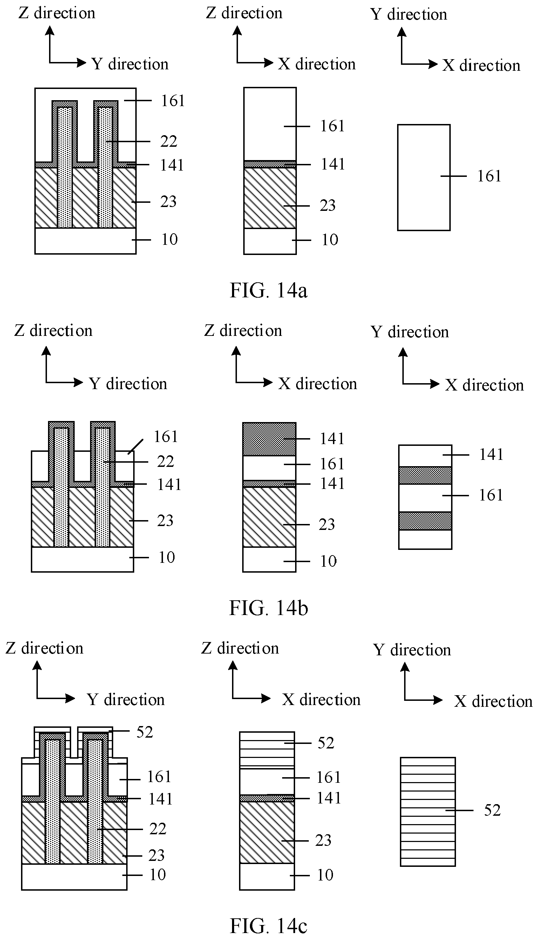

S120: As shown in FIG. 13e, form a third insulation layer 23 on the first sacrificial layer 51, the first electrode 11, and the second insulation layer 22, where the third insulation layer 23 completely covers the first electrode 11, a side wall of the first sacrificial layer 51, and a side wall of the second insulation layer 22, and exposes surfaces of sides that are of the second insulation layer 22 and the first sacrificial layer 51 and that face away from the substrate 10; as shown in FIG. 13f, perform etch-back on the third insulation layer 23, where in a Y direction, a third insulation layer 23 that is etched back is located between the adjacent first electrodes 11 and covers side walls of the first electrodes 11, and exposes surfaces of sides of parts of side walls that are of the second insulation layer 22 and the first sacrificial layer 51 and that face away from the substrate 10, where an etching depth of the third insulation layer 23 determines a vertical distance between the first gate 16 and the first electrode 11 and a vertical distance between the second gate 17 and the first electrode 11; then, as shown in FIG. 14a, sequentially form a gate dielectric layer 141 and a second conductive layer 161 on the third insulation layer 23 and the second insulation layer 22, where the gate dielectric layer 141 completely covers the side wall of the second insulation layer 22, the surface of the side that is of the second insulation layer 22 and that faces away from the substrate 10, and a surface of a side that is of the third insulation layer 23 and that faces away from the substrate 10; and as shown in FIG. 14b, perform etch-back on the second conductive layer 161, to etch the second conductive layer 161 to a specific depth and expose a part of a surface of the gate dielectric layer 141.

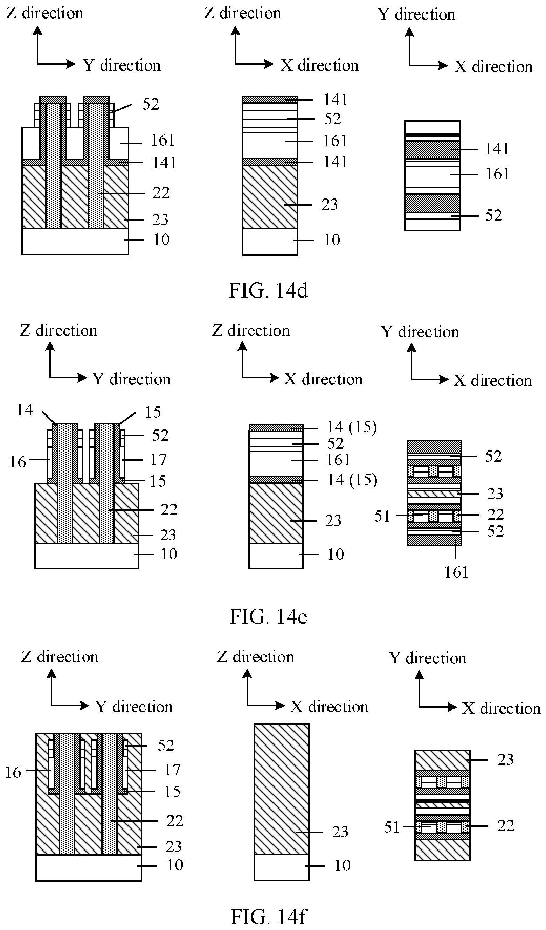

S130: As shown in FIG. 14c, form a second sacrificial layer 52 on the gate dielectric layer 141, where the second sacrificial layer 52 completely covers a side wall of the gate dielectric layer 141, a surface of a side that is of the gate dielectric layer 141 and that faces away from the substrate 10, and a surface of a side that is of the second conductive layer 161 and that faces away from the substrate 10; as shown in FIG. 14d, perform etch-back on the second sacrificial layer 52, and retain a side wall of the second sacrificial layer 52 and keep the side wall in contact with an outer side wall of the gate dielectric layer 141; and as shown in FIG. 14e, under protection of the second sacrificial layer 52, perform etch-back on the second conductive layer 161 and the gate dielectric layer 141, and retain parts that cover the side wall of the second insulation layer 22 and that are in the second conductive layer 161 and the gate dielectric layer 141, where a retained part in the gate dielectric layer 141 is a first gate dielectric layer 14 and a second gate dielectric layer 15, and a retained part in the second conductive layer 161 is the first gate 16 and the second gate 17, both the first gate dielectric layer 14 and the second gate dielectric layer 15 are in contact with an outer side wall of the second insulation layer 22, the first gate 16 is located on a side that is of the first gate dielectric layer 14 and that faces away from the second insulation layer 22, and the second gate is located on a side that is of the second gate dielectric layer 15 and that faces away from the second insulation layer 22.

S140: As shown in FIG. 14f, continue to form an insulation material on the first gate dielectric layer 14, the second gate dielectric layer 15, the first gate 16, the second gate 17, and the second sacrificial layer 52, where the insulation material may be the same as a material of the third insulation layer 23, and is collectively referred to as the third insulation layer 23; and the third insulation layer 23 covers side walls of the first gate dielectric layer 14, the second gate dielectric layer 15, the first gate 16, the second gate 17, and the second sacrificial layer 52.

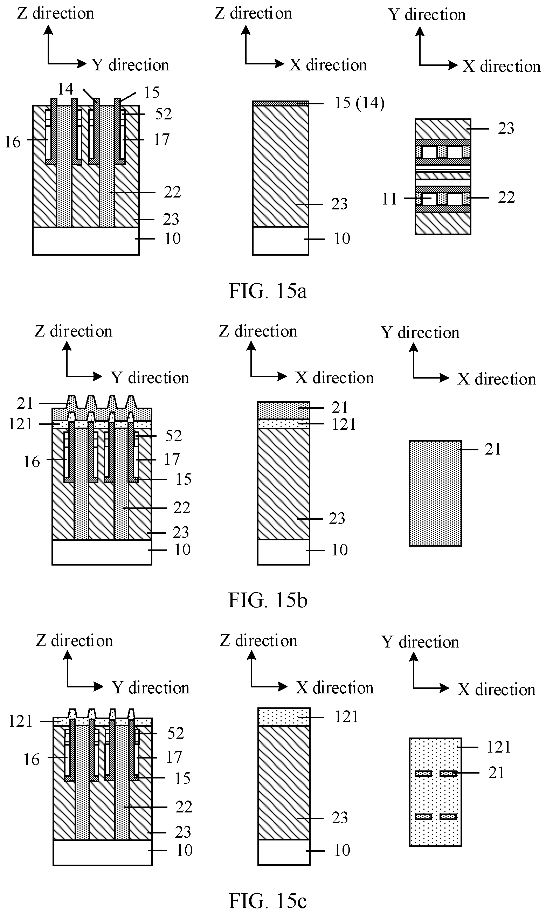

S150: As shown in FIG. 15a, remove the first sacrificial layer 51, and form a recess in a region in which the to-be-formed channel 12 is located, to expose the first electrode 11. The figure shows that in the foregoing procedure, the second insulation layer 22 and the third insulation layer 23 around the first gate dielectric layer 14 and the second gate dielectric layer 15 may alternatively be partially etched, to enable the first gate dielectric layer 14 and the second gate dielectric layer 15 to protrude. As shown in FIG. 15b, sequentially form a semiconductor layer 121 and a first insulation layer 21, where the semiconductor layer 121 and the first insulation layer 21 cover the second insulation layer 22, the third insulation layer 23, the first gate dielectric layer 14, and the second gate dielectric layer 15. The first gate dielectric layer 14 and the second gate dielectric layer 15 protrude, and therefore, parts that are of the semiconductor layer 121 and that overlap the first gate dielectric layer 14 and the second gate dielectric layer 15 also protrude, and a part that is of the semiconductor layer 121 and that overlaps a region between the first gate dielectric layer 14 and the second gate dielectric layer 15 is a trench. Then, as shown in FIG. 15c, perform etch-back on the first insulation layer 21, where after the etching, the first insulation layer 21 is located in the trench of the semiconductor layer 121.

In FIG. 15a, views in a Y-Z direction and an X-Z direction are side views, and the side views do not show the region in which the to-be-formed channel 12 is located. However, it can be seen from a top view in an X-Y direction in FIG. 15a that, after the first sacrificial layer 51 is removed, a surface of a side that is of the first electrode 11 and that faces away from the substrate 10 may be exposed, and a recess is formed in the region in which the to-be-formed channel 12 is located. The recess is formed by the first electrode 11, the second insulation layer 22, the first gate dielectric layer 14, and the second gate dielectric layer 15. Further, the subsequently formed semiconductor layer 121 may be filled in the recess, and after subsequent step S160, a part that is of the semiconductor layer 121 and that is located in the recess is the channel 12.

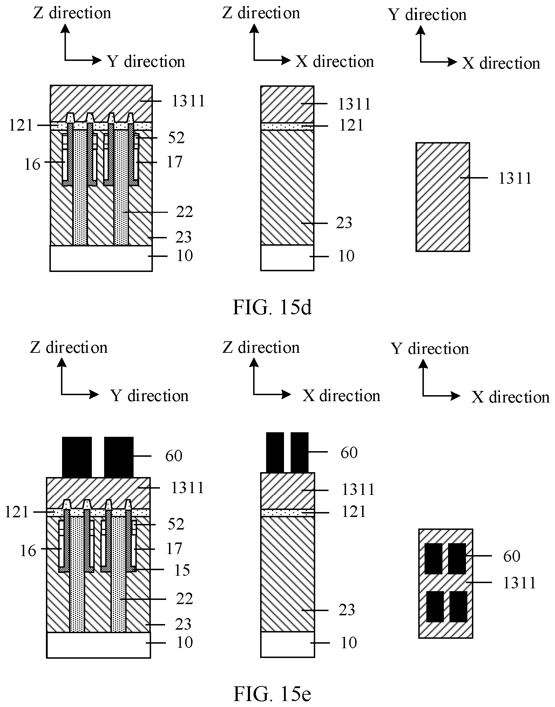

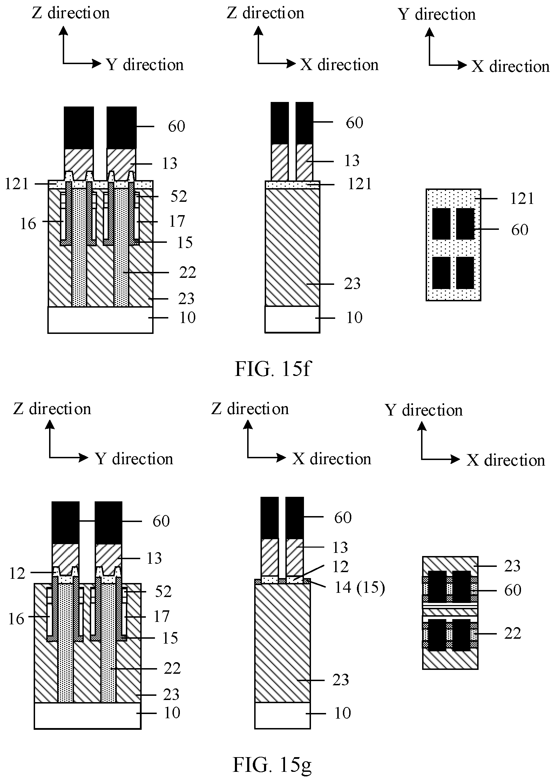

S160: As shown in FIG. 15d and FIG. 15e, sequentially form a third conductive layer 1311 and a hard mask 60 on the semiconductor layer 121 and the first insulation layer 21; as shown in FIG. 15f and FIG. 15g, under protection of the hard mask 60, sequentially partially remove the third conductive layer 1311 and the semiconductor layer 121 to obtain a second electrode 13 and the channel 12, where the second electrode 13 is in contact with a surface that is of the channel 12 and that faces away from the substrate 10; and then, remove the hard mask 60. Therefore, the dual-gate vertical transistor in which both the first gate 16 and the second gate 17 are in contact with the outer side walls of the channel 12 in the first embodiment described above can be obtained.

Certainly, if the second electrode 13 formed in S160 includes a first sub-electrode 131 and a second sub-electrode 132 that are disposed opposite to each other. A first single-gate vertical transistor and a second single-gate vertical transistor (for example, FIG. 8b) may alternatively be formed by the process steps.

In this application, the first sacrificial layer 51 and the second insulation layer 22 are first formed, and trenches are provided between the adjacent first sacrificial layers 51 and between the adjacent second insulation layers 22 through etch-back. Then, the first gate dielectric layer 14, the second gate dielectric layer 15, the first gate 16, and the second gate 17 are formed on side walls of the first sacrificial layer 51 and the second insulation layer 22. Finally, the first sacrificial layer 51 is removed, and the channel 12 is formed at a position of the first sacrificial layer 51, to enable the channel 12 to be in contact with the first electrode 11. In other words, in this application, there is no need to form the second via between the first gate dielectric layer 14 and the second gate dielectric layer 14. This can avoid a case in which a size of the vertical transistor cannot be scaled due to process limitation of forming the second via.

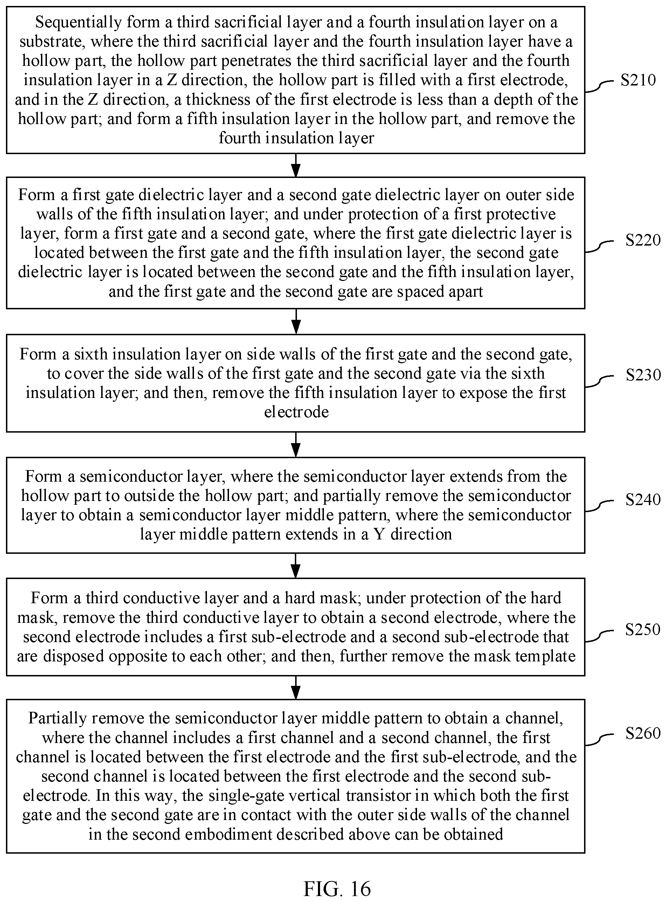

In a second case, both a first gate 16 and a second gate 17 are in contact with outer side walls of a channel 12, and a vertical transistor on the chip includes a first single-gate vertical transistor and a second single-gate vertical transistor. As shown in FIG. 16, the structure may be implemented by the following steps.

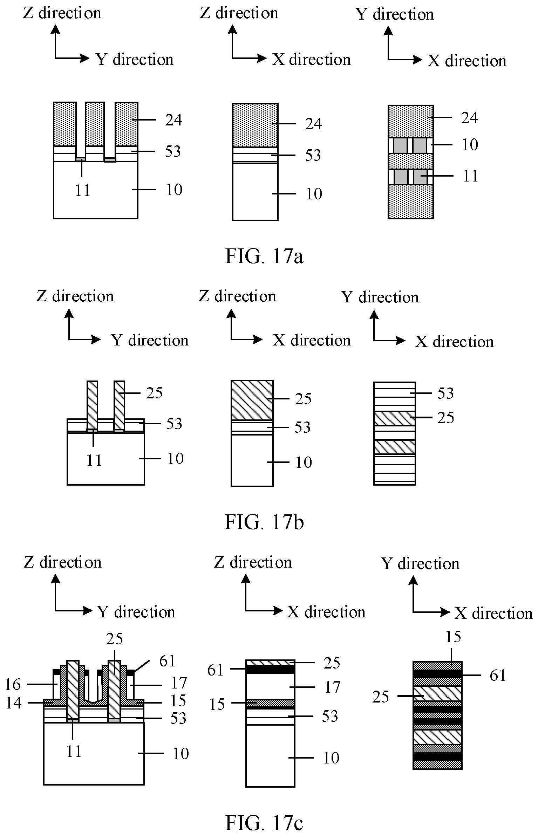

S210: As shown in FIG. 17a, sequentially form a third sacrificial layer 53 and a fourth insulation layer 24 on a substrate 10, where the third sacrificial layer 53 and the fourth insulation layer 24 have a hollow part, the hollow part penetrates the third sacrificial layer 53 and the fourth insulation layer 24 in a Z direction, the hollow part is filled with a first electrode 11, and in the Z direction, a thickness of the first electrode 11 is less than a depth of the hollow part; and as shown in FIG. 17b, form a fifth insulation layer 25 in the hollow part, and remove the fourth insulation layer 24.

S220: As shown in FIG. 17c, form a first gate dielectric layer 14 and a second gate dielectric layer 15 on outer side walls of the fifth insulation layer 25, and under protection of a first protective layer 61, form the first gate 16 and the second gate 17, where the first gate dielectric layer 14 is located between the first gate 16 and the fifth insulation layer 24, the second gate dielectric layer 15 is located between the second gate 17 and the fifth insulation layer 25, and the first gate 16 and the second gate 17 are spaced apart.

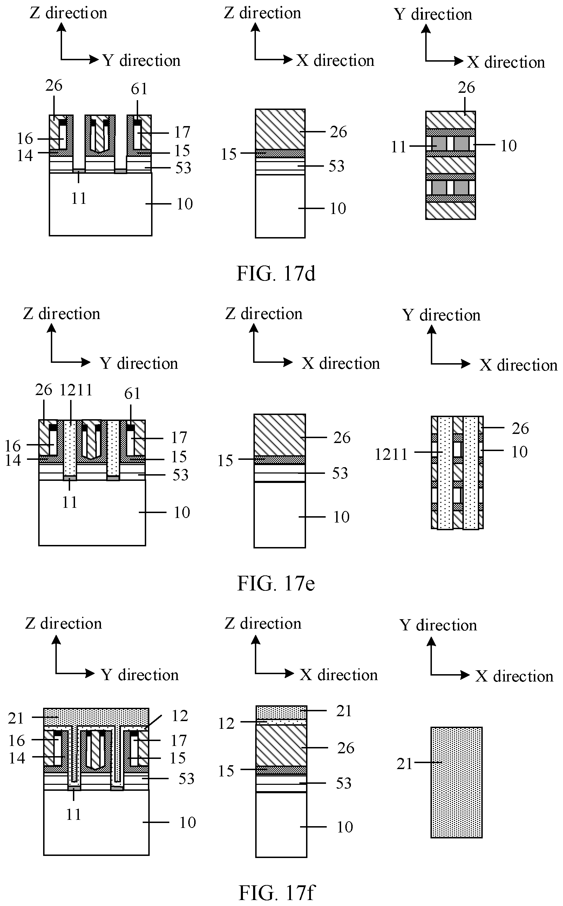

S230: As shown in FIG. 17d, form a sixth insulation layer 26 on side walls of the first gate 16 and the second gate 17, to cover the side walls of the first gate 16 and the second gate 16 via the sixth insulation layer 26; and then, remove the fifth insulation layer 25 to expose the first electrode 11.

S240: Form a semiconductor layer 121, where the semiconductor layer 121 extends from the hollow part to outside the hollow part.

In some possible implementations, as shown in FIG. 17e, if the to-be-formed channel 12 is a solid overall structure or a hollow structure, the semiconductor layer 121 may fill a part of the hollow part other than the first electrode 11. Then, the semiconductor layer 121 is partially removed to obtain a semiconductor layer middle pattern 1211, where the semiconductor layer middle pattern 1211 extends in a Y direction.

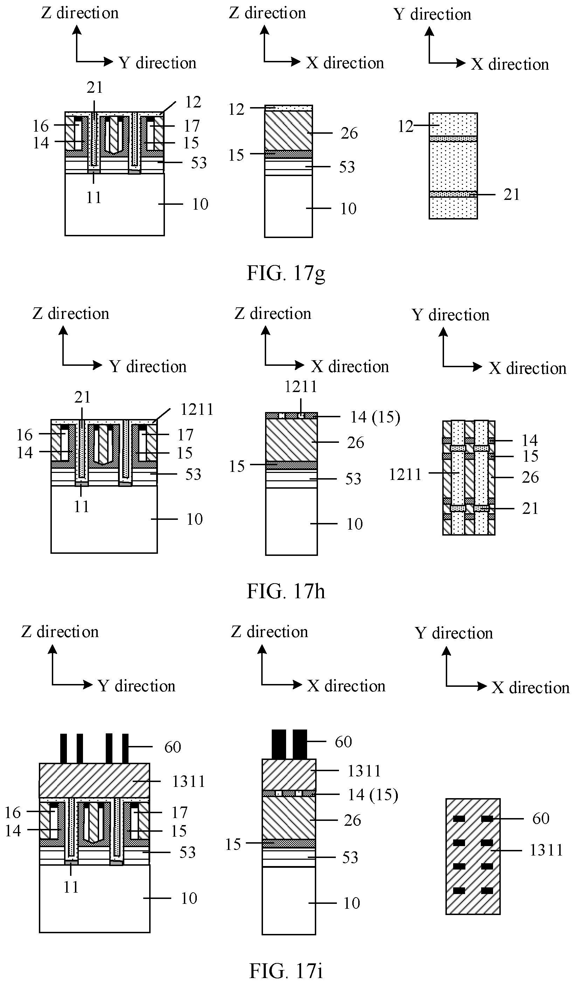

Alternatively, as shown in FIG. 17f, if the to-be-formed channel 12 further has a trench, and the trench is filled with a first insulation layer 21, the semiconductor layer 121 is partially filled with the first electrode 11 that is in contact with a bottom of the hollow part. After the semiconductor layer 121 is formed, the first insulation layer 21 is further filled in the hollow part, and the first insulation layer 21 completely covers the semiconductor layer 121. Then, as shown in FIG. 17g, remove a part other than the hollow part in the first insulation layer 21. As shown in FIG. 17h, partially remove the semiconductor layer 121 to obtain a semiconductor layer middle pattern 1211, where the semiconductor layer middle pattern 1211 extends in a Y direction.

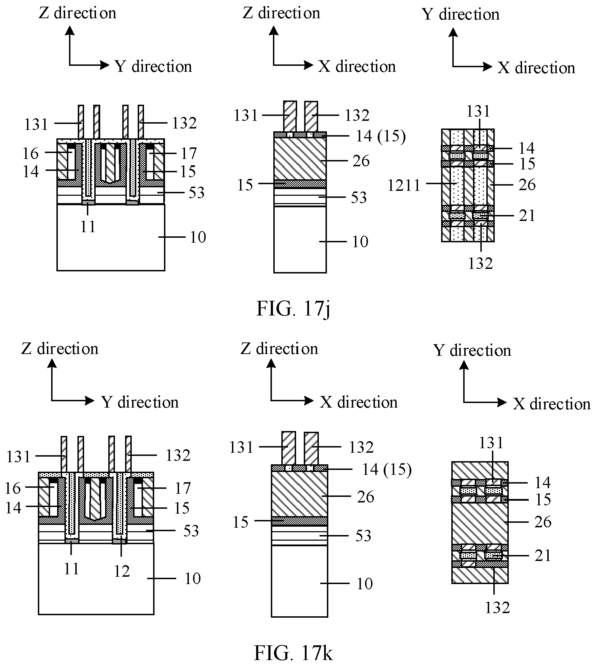

S250: As shown in FIG. 17i, form a third conductive layer 1311 and a hard mask 60; as shown in FIG. 17j, under protection of the hard mask 60, remove the third conductive layer 1311 to obtain a second electrode 13, where the second electrode 13 includes a first sub-electrode 131 and a second sub-electrode 132 that are disposed opposite to each other; and then, further remove the mask template 60.

S260: As shown in FIG. 17k, partially remove the semiconductor layer middle pattern 1211 to obtain the channel 12, where the channel includes a first channel 121 and a second channel 122, the first channel 121 is located between the first electrode 11 and the first sub-electrode 131, and the second channel 122 is located between the first electrode 11 and the second sub-electrode 132. In this way, the single-gate vertical transistor in which both the first gate 16 and the second gate 17 are in contact with the outer side walls of the channel 12 in the second embodiment described above can be obtained.

Certainly, if the second electrode 13 in the vertical transistor formed in S250 is an integral structure instead of including the first sub-electrode 131 and the second sub-electrode 132 that are disposed opposite to each other, and the first channel 121 and the second channel 122 formed in S260 enclose the trench, the first insulation layer 21 may be further filled in the trench, to form the dual-gate vertical transistor (for example, FIG. 2a and FIG. 2b) by the process steps.

In this application, the fifth insulation layer 25 is formed in a region of the to-be-formed channel 12. Then, the first gate dielectric layer 14, the second gate dielectric layer 15, the first gate 16, and the second gate 17 are formed on a side wall of the fifth insulation layer 25. Finally, the fifth insulation layer 25 is removed, and the channel 12 is formed at a position of the fifth insulation layer 25, to enable the channel 12 to be in contact with the first electrode 11. In other words, in this application, there is no need to form the second via between the first gate dielectric layer 14 and the second gate dielectric layer 14. This can avoid a case in which a size of the vertical transistor cannot be scaled due to process limitation of forming the second via.

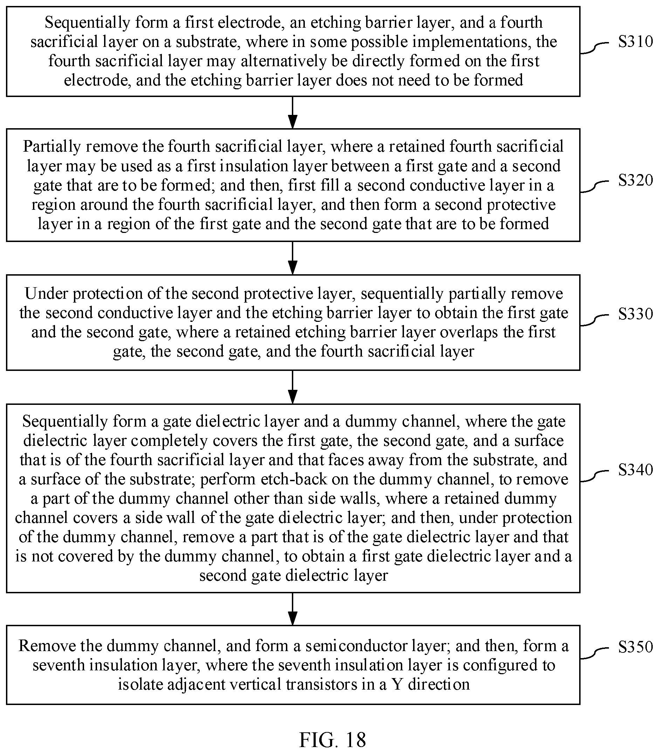

In a third case, both a first gate 16 and a second gate 17 are in contact with inner side walls of a channel 12, and a vertical transistor on the chip may be a dual-gate vertical transistor, or may be a single-gate vertical transistor. As shown in FIG. 18, the structure may be implemented by the following steps.

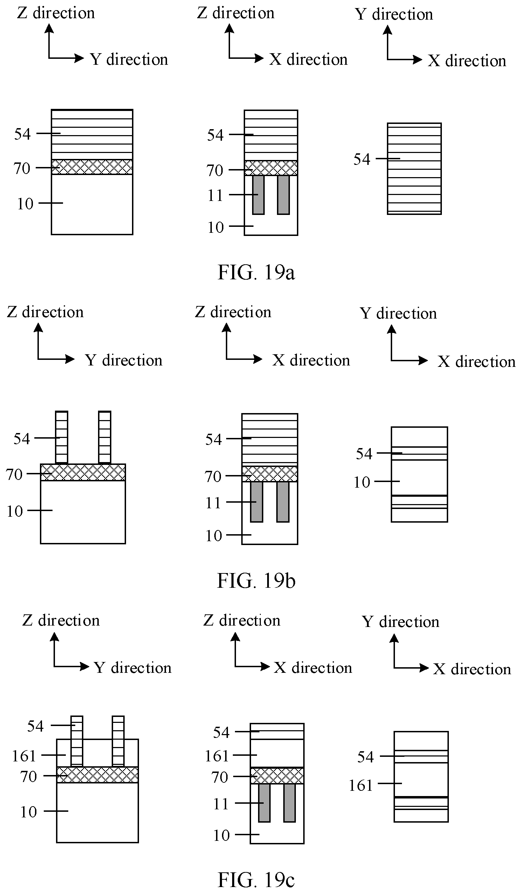

S310: As shown in FIG. 19a, sequentially form a first electrode 11, an etching barrier layer 70, and a fourth sacrificial layer 54 on a substrate 10, where in some possible implementations, the fourth sacrificial layer 54 may alternatively be directly formed on the first electrode 11, and the etching barrier layer 70 does not need to be formed.

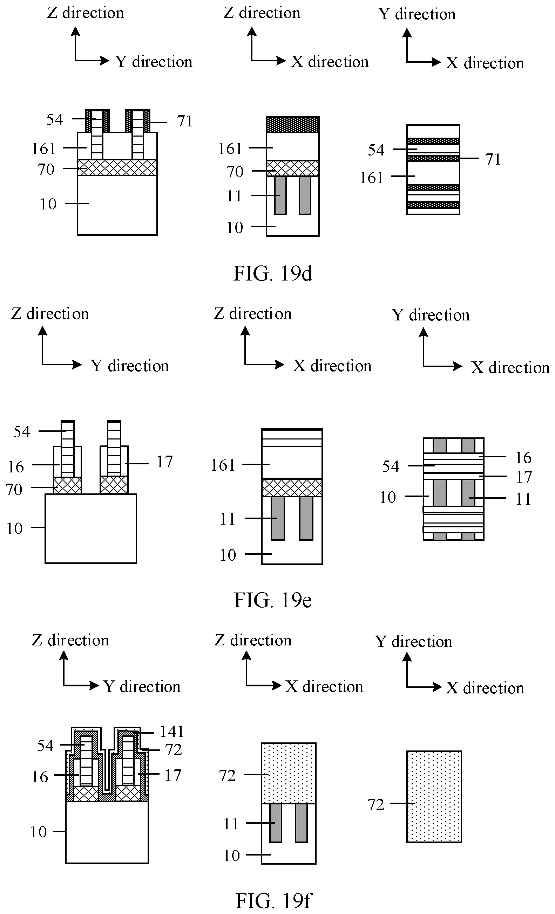

S320: As shown in FIG. 19b, partially remove the fourth sacrificial layer 54, where a retained fourth sacrificial layer 54 may be used as a first insulation layer 21 between the first gate 16 and the second gate 17 that are to be formed; and then, as shown in FIG. 19c and FIG. 19d, first fill a second conductive layer 161 in a region around the fourth sacrificial layer 54, and then form a second protective layer 71 in a region of the first gate 16 and the second gate 17 that are to be formed.

S330: As shown in FIG. 19e, under protection of the second protective layer 71, sequentially partially remove the second conductive layer 161 and the etching barrier layer 70 to obtain the first gate 16 and the second gate 17, where a retained etching barrier layer 70 overlaps the first gate 16, the second gate 17, and the fourth sacrificial layer 54.

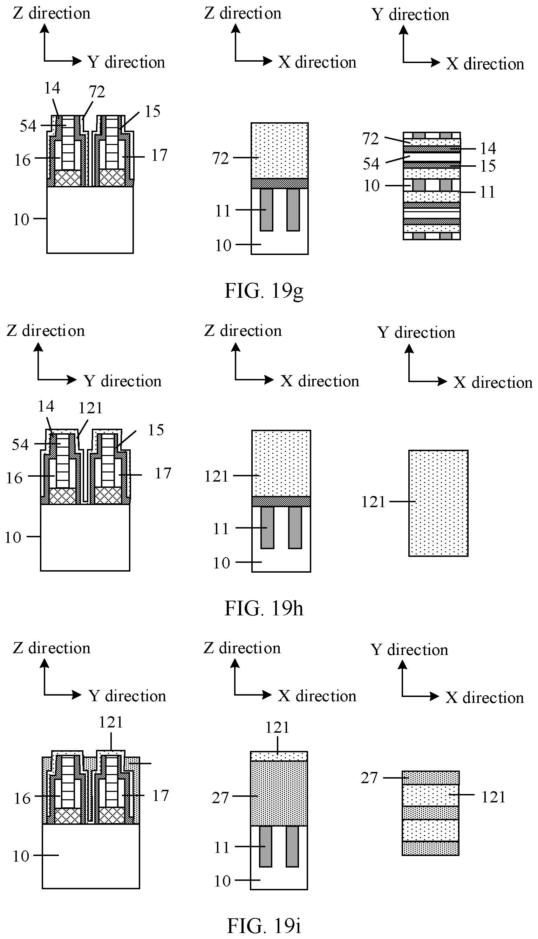

S340: As shown in FIG. 19f, sequentially form a gate dielectric layer 141 and a dummy channel 72, where the gate dielectric layer 14 completely covers the first gate 16, the second gate 17, and a surface that is of the fourth sacrificial layer 54 and that faces away from the substrate 10, and a surface of the substrate 10; perform etch-back on the dummy channel 72, to remove a part of the dummy channel 72 other than side walls, where a retained dummy channel 72 covers a side wall of the gate dielectric layer 141; and then, as shown in FIG. 19g, under protection of the dummy channel 72, remove a part that is of the gate dielectric layer 141 and that is not covered by the dummy channel 72, to obtain a first gate dielectric layer 14 and a second gate dielectric layer 15.

S350: As shown in FIG. 19h, remove the dummy channel 72, and form a semiconductor layer 121; and then, as shown in FIG. 19i, form a seventh insulation layer 27, where the seventh insulation layer 27 is configured to isolate adjacent vertical transistors in a Y direction.

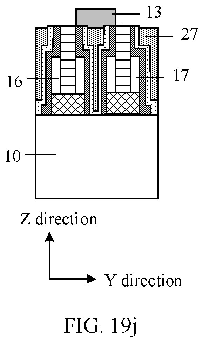

Then, with reference to the foregoing first case and second case, the semiconductor layer 121 may be partially removed based on the dual-gate vertical transistor or the single-gate vertical transistor, to obtain the channel 12; and the second electrode 13 is formed above the channel 12. Details are not described herein again. In addition, as shown in FIG. 19j, after the channel 12 is obtained by the process steps, in the Y direction, FIG. 19j sequentially shows a first channel 121, a second channel 122, a first channel 121, and a second channel 122, and in this application, the second electrode 13 may be further formed on the second channel 122 and the first channel 121 in the middle. In this way, the dual-gate vertical transistor in which the first gate 16 and the second gate 17 are outside the trench proposed in the first embodiment may be further fabricated by the process steps.

In this application, the fourth sacrificial layer 54 is formed in a region of the to-be-formed channel 12. Then, the first gate dielectric layer 14, the second gate dielectric layer 15, the first gate 16, and the second gate 17 are formed on a side wall of the fourth sacrificial layer 54. Finally, the fourth sacrificial layer 54 is removed, and the channel 12 is formed at a position of the fourth sacrificial layer 54, to enable the channel 12 to be in contact with the first electrode 11. In other words, in this application, there is no need to form the second via between the first gate dielectric layer 14 and the second gate dielectric layer 14. This can avoid a case in which a size of the vertical transistor cannot be scaled due to process limitation of forming the second via.

In addition, other explanations and beneficial effect of this embodiment of this application are the same as those of the first two embodiments. Details are not described herein again.

The foregoing describes embodiments of this application with reference to the accompanying drawings. However, this application is not limited to the foregoing specific implementations. The foregoing specific implementations are merely examples, but are not limitative. Inspired by this application, a person of ordinary skill in the art may further make many modifications without departing from the purposes of this application and the protection scope of the claims, and all the modifications shall fall within protection of this application.

## Claims

1. A chip, comprising a vertical transistor, wherein the vertical transistor comprises:
a first electrode, a channel, and a second electrode that are sequentially stacked on a substrate, wherein the channel comprises a trench;
a first gate dielectric layer and a second gate dielectric layer, wherein both the first gate dielectric layer and the second gate dielectric layer are in contact with side walls of the trench; and both the first gate dielectric layer and the second gate dielectric layer are located in the trench, or both the first gate dielectric layer and the second gate dielectric layer are located outside the trench; and
a first gate and a second gate that are spaced apart, wherein the first gate is disposed on a side that is of the first gate dielectric layer and that faces away from the channel, and the second gate is disposed on a side that is of the second gate dielectric layer and that faces away from the channel.

2. The chip according to claim 1, wherein both the first gate dielectric layer and the second gate dielectric layer are located outside the trench, the first gate is disposed on the side that is of the first gate dielectric layer and that faces away from the channel, and the second gate is disposed on the side that is of the second gate dielectric layer and that faces away from the channel.

3. The chip according to claim 2, wherein the chip further comprises a first insulation layer, and the first insulation layer is filled in the trench; or
the trench further comprises a bottom adjacent to and between side walls, the bottom is in contact with the first electrode, and the second electrode is filled in the trench.

4. The chip according to claim 1, wherein both the first gate dielectric layer and the second gate dielectric layer are located in the trench, the chip further comprises a first insulation layer, and the first insulation layer is filled in the trench; and
the first gate is disposed between the first gate dielectric layer and the first insulation layer, and the second gate is disposed between the second gate dielectric layer and the first insulation layer.

5. The chip according to any one of claims 1 to 4, wherein there are a plurality of vertical transistors;
a plurality of vertical transistors arranged in a column direction share a same first electrode; and
a plurality of vertical transistors arranged in a row direction share a same first gate and a same second gate.

6. The chip according to claim 5, wherein when both the first gate dielectric layer and the second gate dielectric layer are located in the trench, channels of adjacent vertical transistors arranged in the column direction are connected.

7. The chip according to any one of claims 1 to 6, wherein the first gate and the second gate are disposed opposite to each other.

8. The chip according to any one of claims 2 and 3 and 5 to 7, wherein
when both the first gate dielectric layer and the second gate dielectric layer are located outside the trench, a longitudinal cross section of the trench is U-shaped, or a transverse cross section of the trench is a closed loop; and
the longitudinal cross section of the trench is an interface of the trench on a plane in which a first direction and a second direction are located, the first direction is a direction in which the first electrode points to the second electrode, and the second direction is a direction in which the first gate points to the second gate; and the transverse cross section of the trench is a cross section of the trench in the second direction.

9. A chip, comprising a vertical transistor, wherein the vertical transistor comprises:
a first electrode, a channel, and a second electrode that are sequentially stacked on a substrate, wherein the second electrode comprises a first sub-electrode and a second sub-electrode that are disposed opposite to each other, and the channel comprises a first channel located between the first electrode and the first sub-electrode and a second channel located between the first electrode and the second sub-electrode;
a first gate dielectric layer and a second gate dielectric layer, wherein the first gate dielectric layer is in contact with a side wall of the first channel, and the second gate dielectric layer is in contact with a side wall of the second channel; and
a first gate and a second gate that are disposed opposite to each other, wherein the first gate is disposed on a side that is of the first gate dielectric layer and that faces away from the first channel, and the second gate is disposed on a side that is of the second gate dielectric layer and that faces away from the second channel.

10. The chip according to claim 9, wherein the first channel and the second channel enclose a trench, the chip further comprises a first insulation layer, and the first insulation layer is filled in the trench.

11. The chip according to claim 10, wherein both the first gate dielectric layer and the second gate dielectric layer are located outside the trench, the first gate is disposed on the side that is of the first gate dielectric layer and that faces away from the first channel, and the second gate is disposed on the side that is of the second gate dielectric layer and that faces away from the second channel; or
both the first gate dielectric layer and the second gate dielectric layer are located in the trench, the first gate is disposed between the first gate dielectric layer and the first insulation layer, and the second gate is disposed between the second gate dielectric layer and the second insulation layer.

12. The chip according to claim 10, wherein the first channel and the second channel are disconnected.

13. A memory, comprising a memory array, wherein the memory array comprises the chip according to any one of claims 1 to 8 or any one of claims 9 to 12; and
the memory array further comprises a capacitor, and the capacitor is electrically connected to a vertical transistor in the chip.

14. The memory according to claim 13, wherein
the memory array comprises the chip according to any one of claims 1 to 8, and the memory array further comprises a word line and a bit line; a gate of the vertical transistor is electrically connected to the word line, a first electrode is electrically connected to the bit line, and a second electrode is electrically connected to the capacitor; or
the memory array comprises the chip according to any one of claims 9 to 12, and the memory array further comprises a write word line, a read word line, and a bit line; and a second gate is electrically connected to the write word line, a second sub-electrode is electrically connected to a first gate, a first sub-electrode is electrically connected to the read word line, and a first electrode is electrically connected to the bit line.

15. An electronic device, comprising a circuit board and the chip according to any one of claims 1 to 8, or the chip according to any one of claims 9 to 12, or the memory according to claim 13 or 14, wherein the chip or the memory is disposed on the circuit board.

16. A fabrication method for a chip, comprising:
forming a first electrode, a first sacrificial layer, a second insulation layer, and a third insulation layer on a substrate, wherein the first sacrificial layer covers a surface of a side that is of the first electrode and that faces away from the substrate; in a third direction, the second insulation layer is located between adjacent first electrodes and between adjacent first sacrificial layers; and in a second direction, the third insulation layer is located between the adjacent first electrodes and covers side walls of the first electrodes;
forming a first gate dielectric layer, a second gate dielectric layer, a first gate, and a second gate on a side that is of the third insulation layer and that faces away from the substrate, wherein the first gate dielectric layer is located between the first gate and the second insulation layer, the second gate dielectric layer is located between the second gate and the second insulation layer, and the first gate and the second gate are spaced apart;
removing the first sacrificial layer to form a recess, so as to expose the surface of the side that is of the first electrode and that faces away from the substrate, and sequentially filling the recess with a channel and a first insulation layer; and
forming a second electrode on a side that is of the channel and the first insulation layer and that faces away from the substrate, wherein the second direction is perpendicular to the third direction, and both the second direction and the third direction are perpendicular to a first direction in which the first electrode points to the second electrode.

17. The fabrication method according to claim 16, wherein the second electrode comprises a first sub-electrode and a second sub-electrode that are disposed opposite to each other, and the channel comprises a first channel and a second channel; and
the first channel is located between the first electrode and the first sub-electrode, and the second channel is located between the first electrode and the second sub-electrode.

18. A fabrication method for a chip, comprising:
forming a third sacrificial layer, a fifth insulation layer, and a first electrode on a substrate, wherein the third sacrificial layer has a hollow part, and the hollow part penetrates the third sacrificial layer; and the first electrode and the fifth insulation layer are filled in the hollow part, and a vertical distance from a surface of a side that is of the fifth insulation layer and that faces away from the substrate to the substrate is greater than a vertical distance from a surface of a side that is of the third sacrificial layer and that faces away from the substrate to the substrate;
forming a first gate dielectric layer, a second gate dielectric layer, a first gate, and a second gate, wherein the first gate dielectric layer is located between the first gate and the fifth insulation layer, the second gate dielectric layer is located between the second gate and the fifth insulation layer, and the first gate and the second gate are spaced apart;
removing the fifth insulation layer and forming a channel in the hollow part, wherein the channel comprises a first channel and a second channel; and
forming a second electrode on a side that is of the channel and that faces away from the substrate, wherein the second electrode comprises a first sub-electrode and a second sub-electrode that are disposed opposite to each other, the first channel is located between the first electrode and the first sub-electrode, and the second channel is located between the first electrode and the second sub-electrode.

19. The fabrication method according to claim 18, wherein the first channel and the second channel enclose a trench; and
before forming the second electrode on the side that is of the channel and that faces away from the substrate, the fabrication method further comprises:
filling the trench with a first insulation layer.

20. The fabrication method according to claim 18 or 19, wherein forming the third sacrificial layer, the fifth insulation layer, and the first electrode on the substrate comprises:
forming the third sacrificial layer and a fourth insulation layer on the substrate, wherein the hollow part penetrates the third sacrificial layer and the fourth insulation layer;
sequentially filling the hollow part with the first electrode and the fifth insulation layer; and
removing the fourth insulation layer.

21. A fabrication method for a chip, comprising:
forming a first electrode and a fourth sacrificial layer on a substrate, wherein the fourth sacrificial layer is located on a side that is of the first electrode and that faces away from the substrate;
respectively forming a first gate and a second gate on two sides of adjacent fourth sacrificial layers; and
forming a first gate dielectric layer, a second gate dielectric layer, a channel, and a second electrode, wherein the channel is disposed on a side that is of the first gate dielectric layer and that faces away from the first gate and a side that is of the second gate dielectric layer and that faces away from the second gate, and the second electrode is located on a side that is of the channel and that faces away from the substrate.

22. The fabrication method according to claim 21, wherein forming the first gate dielectric layer, the second gate dielectric layer, and the channel comprises:
sequentially forming a gate dielectric layer and a dummy channel on the first gate and the second gate;
performing etch-back on the dummy channel, wherein a retained dummy channel covers a side wall of the gate dielectric layer;
removing, under protection of the dummy channel, a part that is of the gate dielectric layer and that is not covered by the dummy channel, to obtain the first gate dielectric layer and the second gate dielectric layer; and
removing the dummy channel, and forming the channel on the side that is of the first gate dielectric layer and that faces away from the first gate and the side that is of the second gate dielectric layer and that faces away from the second gate.
